(19) Europäisches Patentamt / European Patent Office / Office européen des brevets

(11) **EP 3 155 716 B1**

(12) **EUROPÄISCHE PATENTSCHRIFT**

(45) Veröffentlichungstag und Bekanntmachung des Hinweises auf die Patenterteilung:
**24.10.2018 Patentblatt 2018/43**

(21) Anmeldenummer: **15760079.2**

(22) Anmeldetag: **03.06.2015**

(51) Int Cl.:
*H02M 7/483* (2007.01)    *G01R 31/40* (2014.01)
*H02J 7/00* (2006.01)

(86) Internationale Anmeldenummer:
**PCT/DE2015/000277**

(87) Internationale Veröffentlichungsnummer:
**WO 2015/188804 (17.12.2015 Gazette 2015/50)**

(54) **ELEKTRONISCHE SCHALTUNG ZUM VEREINFACHTEN BETRIEB VON MEHRPUNKTUMRICHTERN**

ELECTRONIC CIRCUIT FOR EASIER OPERATION OF MULTILEVEL CONVERTERS

CIRCUIT ÉLECTRONIQUE SIMPLIFIANT LE FONCTIONNEMENT DE CONVERTISSEURS MULTIPOINTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.06.2014 DE 202014004749 U**

(43) Veröffentlichungstag der Anmeldung:
**19.04.2017 Patentblatt 2017/16**

(73) Patentinhaber: **Dr.Ing. H.C. F. Porsche Aktiengesellschaft 70435 Stuttgart (DE)**

(72) Erfinder: **GOETZ, Stefan 85659 Forstern (DE)**

(56) Entgegenhaltungen:
• **L. ÄNQUIST; A. ANTONOPOULOS; D. SIEMASZKO; K. ILVES; M. VASILADIOTIS; H-P. NEE: "Open-loop control of modular multilevel converters using estimation of stored energy", IEEE TRANSACTIONS ON INDUSTRY APPLICATIONS, Bd. 47, Nr. 6, 2011, Seiten 2516-2524, XP002745765, in der Anmeldung erwähnt**

**Beschreibung**

*Überblick*

Bei der vorliegenden Erfindung handelt es sich um eine elektronische Schaltung mit zugehöriger Steuerung, die beispielsweise für effiziente leistungselektronische Stromversorgungen, elektrische Umrichter, elektrische Wechselrichter und Batterie-integrierte Umrichter, oder Batteriesysteme mit der Möglichkeit zur dynamischen Änderung der Konnektivität individueller Batterieteile (beispielsweise seriell oder parallel) verwendet werden kann.

Beispiele für derartige leistungselektronische Schaltungen sind der Modulare Multilevelumrichter M2C (siehe US 7,269,037; DE 101 03 031) oder der Modulare Multilevel-Parallel-Seriell-Umrichter M2SPC (siehe WO2012072197; DE102010052934; WO2012072168; WO2012072197; EP20110179321; DE20101052934; WO2013017186; DE102011108920). Ferner erfüllen auch sogenannte Switched-Capacitor-Schaltungen die notwendige Vorraussetzungen für eine Verwendung zusammen mit der vorliegenden Erfindung, d.h. die Verwendung mehrerer Energiespeicher, deren elektrische Verschaltung untereinander dynamisch variiert werden kann, um Energie zwischen den Energiespeichern auszutauschen und/oder elektrische Parameter (insbesondere Strom und/oder Spannung) an Anschlüssen für externe Systeme (beispielsweise Energienetze, elektrische Verbraucher oder Quellen) zu kontrollieren. Die Erfindung ist dabei nicht notwendig an einen bestimmten Umrichter oder Modultyp gebunden.

*Stand der Technik*

Als Modul wird im folgenden jegliche Einheit in einer leistungselektronischen Schaltung mit mehreren elektrischen Energiespeichern bezeichnet, die jeweils einen Energiespeicher und mindestens einen elektronischen Schalter enthält, der dazu beiträgt, die elektrische Verschaltung des mindestens einen Energiespeichers des Moduls mit mindestens einem Energiespeicher eines anderen Moduls dynamisch zu verändern. Diese Veränderung der elektrischen Verschaltung des mindestens einen Energiespeichers mit mindestens einem Energiespeicher eines anderen Moduls kann beispielsweise auch den Wechsel von einer praktischen Serienschaltung dieser Energiespeicher zu einem Umgehen eines oder mehrerer dieser Energiespeicher durch Vorbeileiten des Stromes am Energiespeicher ohne diesen zu laden oder zu entladen (sogenannter Bypass-Zustand) bezeichnen. Somit trifft der Begriff auch auf switched-Capacitor-Schaltungen zu. Im Folgenden werden all diese Schaltungen als Umrichter bezeichnet. Unterschiedliche Module können beispielsweise auf getrennten elektronisehen Einheiten, beispielsweise elektronischen Platinen, unabhängig voneinander gefertigt werden, um in der Produktion Kostenverringerungseffekte aufgrund höherer Stückzahlen ähnlicher Einheiten zu nutzen, und/oder Wartung durch einfache Austauschbarkeit von potentiell abgeschlossenen Einzelmodulen zu nutzen.

Als Schaltzustand eines Moduls wird die Art bezeichnet, in der oder die Schalter des Moduls aktiviert oder deaktiviert werden, um mindestens einen elektrischen Energiespeicher des Moduls elektrisch leitend mit mindestens einem elektrischen Energiespeicher mindestens eines anderen Moduls in unterschiedlicher Art, der sogenannten Konnektivität, zu verbinden oder explizit nicht zu verbinden (offener Stromkreis bzw. getrennte Verbindung), dass mehrere Module zusammen eine elektrische Spannung erzeugen. Beispiele für mögliche Konnektivitäten von elektrischen Energiespeichern sind beispielsweise Parallelschaltung und Seriellschaltung, Kombinationen von elektrischen Energiespeichern, sowie unverbundene oder nur mit einem Kontakt verbundene Energiespeicher.

Beispielhafte elementare Schaltungen aus dem Stand der Technik, die Basis für die Erfindung sein können, sind der modulare Multilevelconverter M2C (US 7,269,037; DE 101 03 031), der modulare Multilevelconverter M2SPC (WO2012072197; DE102010052934; WO2012072168; WO2012072197; EP20110179321; DE20101052934; WO2013017186; DE102011108920) sowie die meisten sog. Switched-Capacitor-Schaltungen (siehe beispielsweise [M. D. Seeman, S. R. Sanders (2008). Analysis and optimization of switched-capacitor dc-dc converters. IEEE Transactions on Power Conversion, 23(2):841 ff.]). Modulare Multilevelconverter wie der M2C oder der M2SPC basieren auf der Zusammenschaltung von Modulen mit in der Regel deutlich niedrigerer Spannung als die gesamte Ausgangsspannung des daraus gebildeten modularen Umrichters. Je nach Umrichtertyp wird durch die entsprechende Modulverschaltung Gesamtspannung, Gesamtstrom und notwendige Schaltrate der einzelnen elektronischen Schaltern gegenüber eines traditionellen Umrichters mit weniger als vier Leveln (beispielsweise H-Brücken) in kleine Teileinheiten zerlegt. Im M2C bestehen einzelne Module beispielsweise aus einem Energiespeicher, beispielsweise einem Kondensator, und mehreren elektronischen Schaltern, die entweder in einer Halbbrücke oder einer Vollbrücke angeordnet sind. Jedes M2C-Modul ist damit ein Zweipol, das beispielsweise mit anderen Modulen in Serie und/oder parallel verschaltet werden kann, um eine sogenannte Makrotopologie, d. h. eine Vereinigung von Modulen zur Erfüllung von elektrischen Umrichteraufgaben, zu formen.

Daneben existieren weitere Ableitungen und Entwicklungen wie beispielsweise beschrieben in US 13/990,463; US 14/235,812; DE 10 2010 008978; DE 10 2009 057288; US 3,581,212.

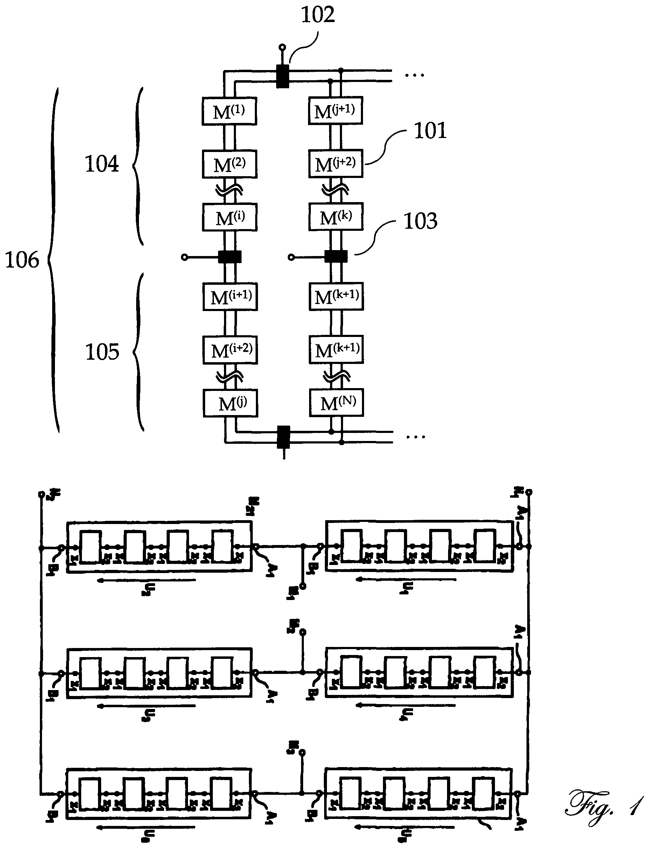

Derartige Module, genannt Microtopologien, können in unterschiedlicher Weise miteinander in sogenannten Makrotopologien verknüpft werden. Bei der am häufigsten anzutreffenden Makrotopologie handelt es sich um die Marquardt-Topologie (siehe US 7,269,037; DE102010052934), die in Abbildung 1 für den M2C und den M2SPC dargestellt ist. Bei dieser Makrotopologie werden mehrere Phasenmodule oder Phaseneinheiten, die selbst aus Konverterarmen (die Zusammenschaltung mindestens zweier Module) bestehen, an den Enden miteinander verbunden. Daneben existieren zahlreiche weitere Varianten zur Verschaltung von Modulen, im einfachsten Fall eine offene Kette von Modulen.

In nahezu allen Makrotopologien ist die kleinste Einheit der sogenannte Konverterarm (Converter arm). Er stellt einen Strang aus mindestens zwei miteinander verbundenen ähnlichen Modulen dar. Die Ähnlichkeit ist bereits dadurch gegeben, dass die benachbarten Module mindestens zwei gemeinsame Zustände (beispielsweise seriell positiv und bypass) gemeinsam aufweisen und im Betrieb mit dynamischen Wechseln zwischen diesen einsetzen können.

Typische Beispiele für Switched-Capacitor-Schaltungen sind Spannungspumpen, bei welchen elektrische Energiespeicher, beispielsweise Kondensatoren, ihre Konnektivität von einer (teilweisen) Serienschaltung in eine (teilweise) Parallelschaltung wechseln können und damit ihre erzeugte Spannung ändern. Ein Beispiel hierfür ist der Marx-Converter, oft als Marx-Generator bezeichnet [siehe Erwin Marx (1925). Erzeugung von verschiedenen Hochspannungsarten zu Versuchs- und Prüfzwecken. Elektrotech. Zeitschrift], und dessen Abwandlungen [beispielsweise J. Rodriguez, S. Leeb (2006). A multilevel inverter topology for inductively coupled power transfer. IEEE Transactions on Power Electronics, 21(6):1607ff.; F. Peng, W. Qiang, D. Cao (2010). Recent advances in multilevel converter/inverter topologies and applications. International Power Electronics Conference (IPEC), 492ff.]. Derartige Schaltungen existieren sowohl als Gleichspannungswandler, Inverter und Umrichter. Durch geeignete Aufteilung der Schaltung in Teile, die jeweils mindestens einen Energiespeicher und mindestens einen elektrischen Schalter enthalten, lassen sich derartige Schaltungen modularisieren. Dies birgt Vorteile in der industriellen Produktion. Der oben genannte modulare Multilevelconverter M2SPC kann als Vereinigung oder Hybrid von traditionellen Multilevelconvertern und Switched-Capacitor-Convertern betrachtet werden.

Ein zentrales Problem beim Betrieb vieler derartiger Schaltungen, die aus einer Anzahl von elektrischen Speichern bestehen, deren elektrische Verschaltung untereinander (Konnektivität) dynamisch im Betrieb geändert werden kann - beispielsweise dynamisch von einer elektrischen Serienschaltung zu einer elektrischen Parallelschaltung gewechselt werden kann, um dabei die Gesamtspannung, den Gesamtinnenwiderstand und den Strom je Modul zu verringern -, liegt in der Ausbalancierung der in jedem Modul gespeicherten Energie. In der Regel handelt es sich bei den Speichern um elektrische Kondensatoren und/oder Batterien. Diese dürfen dabei in der Regel bestimmte Spannungsgrenzen nicht unter- oder überschreiten und sollten vorteilhafter Weise gleichzeitig bestimmte weitere Bedingungen hinsichtlich ihrer elektrischen Bedingungen (insbesondere Spannung und Strom) erfüllen, um nicht übermäßig schnell zu altern. Wegen des beständigen Energieaustausches jedes Moduls mit seinen Nachbarn sowie über alle Anschlüsse mit externen Systemen (beispielsweise dem Stromnetz, einem Motor oder einem Generator) dient die dynamisch änderbare Konnektivität einerseits zur gezielten Beeinflussung des Energieinhaltes jedes Moduls durch Laden oder Entladen. Andererseits ist für ein gezieltes Balanzieren sowie Symmetrieren der Energieinhalte einzelner Module oder das Steuern der elektrischen Bedingungen (insbesondere Spannung und Strom) in der Regel eine genaue Kenntnis der aktuellen und/oder vergangenen elektrischen Bedingungen der jeweiligen Module vonnöten. Auf dieser Datenbasis treffen ein oder mehrere Steuereinheiten Entscheidungen über die zu verwendende Konnektivität in der Zukunft, um die elektrischen Bedingungen wie Spannung, Strom und Energieinhalt der einzelnen Module mit deren integrierten Energiespeichern vorgegebenen oder ermittelten Zielwerten, gewöhnlich durch gezielte Regelung, anzupassen.

In konventionellen Lösungen wird hierzu in der Regel eine aufwändige Messung der elektrischen Bedingungen (insbesondere Spannung und Strom) der einzelnen Module durchgeführt und an einen oder mehrere Steuereinheiten übertragen.

Um die hohen erforderlichen Sicherheits- und Stabilitätsbedingungen zu gewährleisten, erfolgt diese Messung in der Regel mit mehreren Kilohertz Abtastrate. Beim Einsatz von deutlich mehr als hundert Modulen in vielen industriellen Implementierungen des Modularen Multilevelconverters M2C fallen dabei hoch aufgelöst abgetastete Messdaten von Spannung und Strom mit mehreren Megahertz Datenrate an, die zur Zentraleinheit übertragen und dort verarbeitet werden müssen. Da die einzelnen Messpunkte in den Modulen nicht auf ein gemeinsames Referenzpotential bezogen sind und das Grundpotential in jedem Modul ferner von der Konnektivität aller anderen Module abhängt, muss die Messwertaufnahme und die Messwertübertragung elektrisch isoliert (potentialgetrennt) erfolgen. Dies erhöht einerseits die Komplexität und Fehleranfälligkeit des Systems, andererseits verursacht dieser Umstand hohe Kosten, weil die Übertragung auf teure Bauteile zurückgreifen muss, beispielsweise schnelle optische Übertragung.

In der Literatur sind einige wenige Ansätze zur Abhilfe dieses Problems diskutiert worden. L. Änquist et al. (2011) [L. Änquist, A. Antonopoulos, D. Siemaszko, K. Ilves, M. Vasiladiotis, H.-P. Nee (2011). Open-loop control of modular multilevel Converters using estimation of stored energy. IEEE Transactions on Industry Applications. 47(6):2516ff.] beschreiben beispielsweise eine Methode zur Schätzung des Energieinhaltes in jedem Modul auf der Basis des gemessenen Stromes in einem Arm. Gegenüber dem momentan vorherrschenden Ansatz, das Ausbalanzieren, Symmetrieren und Regeln des Energieinhaltes auf der Basis von Messwerten über jedes Modul durchzuführen, spart dieser Ansatz einen Großteil der erforderlichen Sensoren, reduziert die zu verabeitende Datenmenge um mehrere Größenordnung und kann aufgrund der eliminierten Verzögerung der Messwertaufnahme und Multiplexing von Daten kürzere Regelreaktionszeiten bereitstellen. Der Energieinhalt der Energiespeicher in jedem Modul wird auf der Basis des jeweiligen Modulsstromes geschätzt. Der Modulstrom wiederum ist selbst ein Schätzwert, der aus dem gemessenen Armstrom und des elektrischen Schaltungszustandes des Moduls (d.h. die Konnektivität, in diesem Fall Seriellschaltung oder Bypass) abgeleitet wird. Die Ermittlung des Energieinhaltes des zugehörigen Modulspeichers erfolgt durch Ermittelung der Nettoladung über die Zeit durch den jeweiligen Modulstrom.

Allerdings birgt dieser Lösungsansatz ein substantielles Problem. Die Schätzung der einzelnen Modulenergieinhalte basiert auf der Akkumulierung des Stromes und enthält folglich ein zeitliches Integral über einen Strommesswert. Dieses Integral ist dabei kein Kurzzeitintegral zur Mittelung von Rauschen (beispielsweise in der Form eines Tiefpassfilters), sondern die Berechnung einer Ladung. Insbesondere Strommessungen sind stets als fehlerbehaftet anzusehen. Insbesondere sind leichte Messoffsets, also Abweichungen des gemessenen Nullpunkts vom tatsächlichen, in nahezu allen Strommesssystemen vorhanden. Ferner sind praktische Messsysteme oft selbst integrierend oder differenzierend (beispielsweise typische Hall-Sensor-basierte Strommesszangen oder Rogowski-Spulen) und damit überhaupt nicht in der Lage Gleichanteile zu messen.

Durch das Integral über den Strom bei der Bestimmung der Energieinhalte der Energiespeicher (auch als Ladezustand oder State of Charge, kurz SOC, bezeichnet) werden kleine Messoffsets über die Zeit beliebig stark verstärkt. Durch das Integral über die Zeit können selbst kleinste dauerhafte Offsets wie beispielsweise von einem Analog-digital-Konverter hervorgerufene Abweichungen zu einer substantiellen Über- oder Unterschätzung des tatsächlichen Energieinhaltes in den einzelnen Modulen führen. Ein Ausgleich oder ein Erkennen des Fehlers in einer Steuereinheit sind nur bei vollständigem Bekanntsein der langfristige Energieaufnahme an allen Schnittstellen (Anschlüssen) zu externen Systemen möglich. Beispielsweise gehen Änquist et al. (2011) von perfekt harmonischen Strömen aus, die offsetfrei sind, wodurch ein potentielles Offset in den Messwerten entdeckt werden könnte. Da allerdings ein realer Umrichter die Ströme gegenüber seinen externen Anschlüssen und in seinen Armen selbst steuern kann und somit bei Fehleinschätzung sehr wohl netto mehr (oder weniger) Energie aufnehmen kann als er abgibt, ist eine solche Annahme nicht hilfreich.

Ferner ist die beschriebene Lösung nur für sehr spezielle Umrichter und Betriebsbedingungen. Beispielsweise wird von einem DC/AC-Umrichter ausgegangen. Als Module können ausschließlich M2C-Module mit deren sehr begrenzten Modulzustaänden (Seriellschaltung und Bypass) eingesetzt werden. Bei M2SPC-Modulen mit deren paralleler Konnektivität oder auch anderen Modultopologien scheitert der Ansatz. Ferner muss der Lösungsansatz für sein Funktionieren jegliche realen Probleme von leistungselektronischen Schaltungen verzichten. Darunter fallen insbesondere Innenwiderstände aller Bauteile sowie Leckströme in elektronischen Schaltern und Speicherelementen, beispielsweise Kondensatoren und Batterien. Wegen der hohen Fertigungsstreuung dieser beiden Eigenschaften selbst in Bauteilen gleicher Serie, können diese jedoch gerade in einem integrierenden Ansatz nicht vernachlässigt werden.

In kommerziellen Umrichtersystemen basierend auf modularen Multilevelumrichtern, die oft mehrere hundert Millionen Dollar kosten können und für den unterbrechungsfreien Einsatz über mehrere Jahre (folglich die Integrierzeit in obigem Lösungsansatz aus dem Stand der Forschung) ausgelegt sein müssen, ist eine systematische Gefährdung durch ein mangelhaftes Regelsystem mit systematischen Fehlem, die fast unweigerlich zu einer Zerstörung des Systems und gegebenenfalls Bränden fuhren, somit nicht vorteilhaft.

Alternative, stabilere technische Ansätze zur Lösung des Problems der notwendigen genauen Kenntnis der elektrischen Parameter in jedem Model wurden bislang nicht vorgestellt. Einerseits wurde das praktische Problem bei der Verwendung von zeitlich integrierten Strommesswerten nicht ausreichend gewürdigt oder in realistischen Testumgebungen getestet. Andererseits gilt in Fachkreisen eine andere Lösung dieses technischen Problems als schwer und wurde auch von Industrieentwicklungsabteilungen noch nicht zufriedenstellend gelöst. Aus diesem Grund wird trotz der überaus hohen Kosten weiterhin industriell ausschließlich eine Vermessung und Überwachung jedes einzelnen Energiespeichers zum betrieb derartiger Umrichter eingesetzt.

### Kurzbeschreibung der Erfindung

Aus der Analyse des Standes der Forschung ist bekannt, dass eine Verwendung von Strommessungen als Hauptquelle für die Schätzung des Energieinhaltes der Energiespeicher in einzelnen Modulen mit prinzipiellen Problemen behaftet ist und aus diesem Grund nicht verwendet werden sollte.

Die vorliegende Erfindung geht einen grundlegend anderen Weg gemäß den Merkmalen der unabhängigen Ansprüche 1 und 11. Anstatt über den Zu- und Abfluss von Energie und/oder Ladung den Energieinhalt in einzelnen Modulen und/oder Energiespeichern zu berechnen, wird eine Inversschätzung vorgenommen. Dabei können Linearitäten des Systems genutzt werden, um den Umrichter wie ein Codierungssystem zu behandeln, dessen Code mit einer technischen Lösung systematisch ermittelt wird. Da es sich bei nahezu allen modularen Multilevelconvertern und Switched-Capacitor-Convertem um Spannungsquellen handelt, wird die Spannung als zentrales Messergebnis und Maßeinheit verwendet.

Im linearen Fall lässt sich das Problem sehr einfach als Basiserzeugung für einen Vektorraum und/oder die Lösung einer Matrix-Vektor-Gleichung beschreiben. Beides lässt sich überaus vorteilhaft und effizient in integrierter Elektronik darstellen und lösen. Eine Gleichung kann ferner als mathematische Kombination betrachtet werden. Die Begriffe Variable, Parameter und Faktor folgen weitestgehend Folgendem: Eine Variable bezeichnet den Wert eines Parameters, in einer Formel oder Gleichung tritt sie auch als Faktor auf. Im Folgenden sind diese äquivalent zu verstehen. Strommesswerte werden dabei absichtlich nicht in zeitlich integrierter Form eingesetzt, wenn dieses zeitliche Integral kein rauschmittelndes Kurzzeitintegral (oder Filter-Integral) sondern eine Ladungsberechnung und somit ein Langzeitintegral darstellt. Typische Integrierzeiten überschreiten dabei die Periodendauer des vom Umrichter erzeugten oder aufgenommenen Wechselstroms (beispielsweise 20 ms im 50 Hz-Spannungsnetz). In der Regel überschreiten solche Integrierzeiten zur Ermittlung der Ladung die Dauer mehrerer Stunden.

### Figuren

Figur 1 zeigt zwei bekannte modulare Multilevelumrichtertopologien (M2C und M2SPC) aus dem Stand der Technik mit Konverterarmen (104, 105) und Phaseneinheiten (106) gemäß dem Stand der Technik.

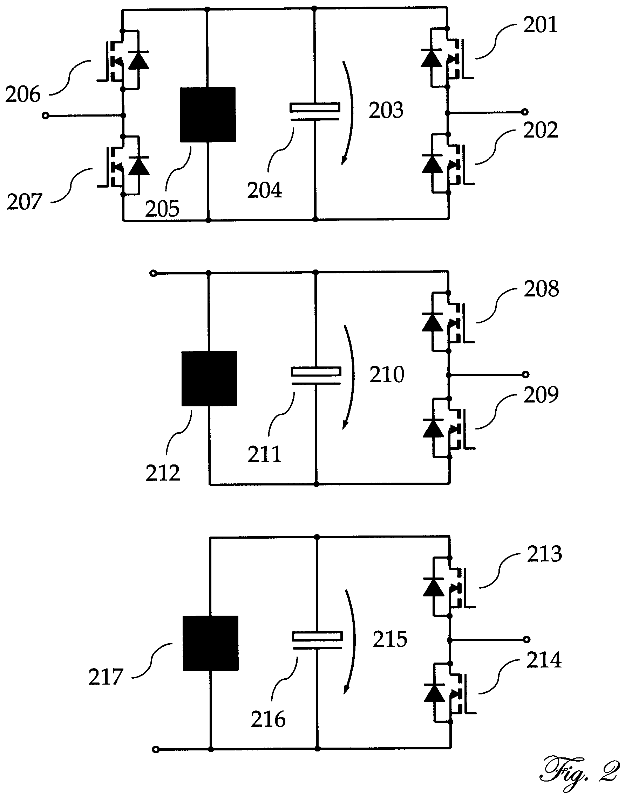

Figur 2 zeigt drei bekannte Modultopologien für modulare Multilevelconverter aus dem Stand der Technik, die in der Regel mindestens einen Energiespeicher (204; 211; 216), der hier als Kondensator dargestellt ist aber auch andere elektrische Komponenten (205; 212; 217) repräsentieren kann, die Energie abgeben und/oder aufnehmen können, und mindestens einen elektronischen Schalter (201, 202, 206, 207; 208, 209; 213, 214) enthalten. Ferner können noch weitere Elemente enthalten sein. Derartige Module beinhalten mindestens zwei Modulterminals, die als elektrische Klemmen verwendet werden können, um ein Modul mit weiteren zu verbinden.

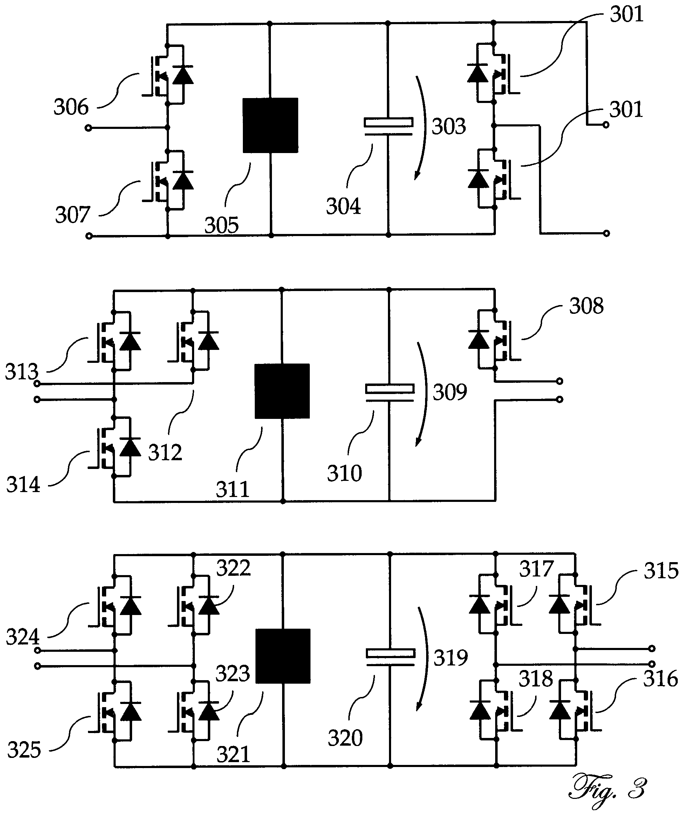

Figur 3 zeigt drei bekannte Modultopologien für modulare Multilevelconverter aus dem Stand der Technik, vier Modulterminals enthalten, um weitere Zustände im Gegensatz zu jenen Modulen aus Figur 2 zu erzeugen. Diese Zustände sind beispielsweise für den Konverter M2SPC notwendig. Module können ferner auch mehr als vier Modulterminals besitzen, um weitere Funktionen zu integrieren.

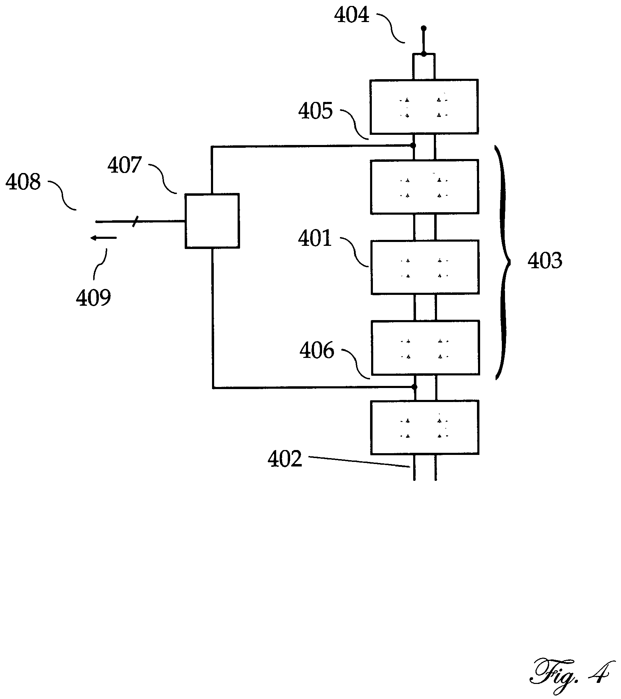

Figur 4 zeigt eine Ausführungsform der Erfindung. Über einen Teilstrang (403) eines Stranges aus Modulen (401), die in diesem Fall ohne Beschränkung der Allgemeinheit über jeweils zwei elektrische Verbindungsleitungen (402) zwischen benachbarten Modulen verfügen, wird von mindestens einem Spannungsmesssystem (407) mit den Messpunkten (405) und (406) mindestens eine dynamische Spannung gemessen und als analoges oder digitales Signal (408) an eine oder mehrere integrierte Schaltungen (409) übermittelt. Der Teilstrang (403) kann lediglich einen Teil eines Umrichters oder auch einen gesamten Umrichter umfassen und alle Module einschließen. Das Signal (408) kann auf einer oder mehreren physikalischen Leitungen übermittelt werden, die elektrisch, optisch, magnetisch oder mit anderen bekannten Übermittlungsmedien implementiert sind.

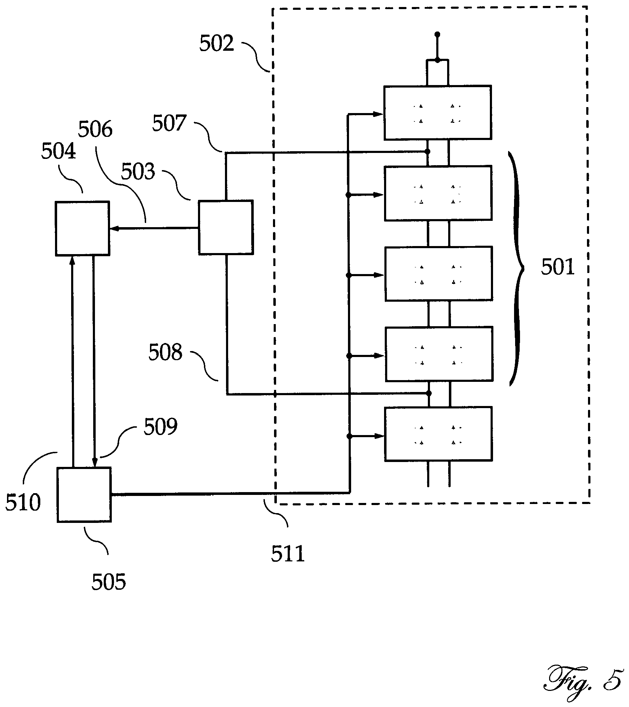

Figur 5 zeigt eine Ausführungsform der Erfindung, in der die gemessene Spannung als analoges oder digitales Signal (506) an mindestens eine integrierte Schaltung (504) übermittelt wird, die als Schätzer fungiert. Die mindestens eine integrierte Schaltung (504) erhält als zusätzliches Eingangssignal den aktuellen (der Messung zugehörigen) Zustandsvektor s (510) der Module. Auf der Basis des Spannungsmesssignals (506) und des Zustandsvektors s (510) ermittelt die integrierte Schaltung (504) elektrische Eigenschaften (509) der Module, die mindestens Schätzungen der Modulspannungen des Teilstranges (501, 403) enthalten und an mindestens eine integrierte Schaltung (505), die als Steuerung des Umrichters fungiert, übermittelt werden. Die integrierte Schaltung (505) ermittelt mithilfe der elektrischen Eigenschaften (509) der Module einen neuen zu verwendenden Zustandsvektor s, der als Signal (511) an den Umrichter übermittelt wird, um dort von den elektronischen Schaltern in den Modulen eingenommen zu werden. Der neue zu verwendende Zustandsvektor s kann dabei die Module des Teilstranges (501), mehr Module, weniger Module oder andere Module enthalten und diesen auch übermittelt werden.

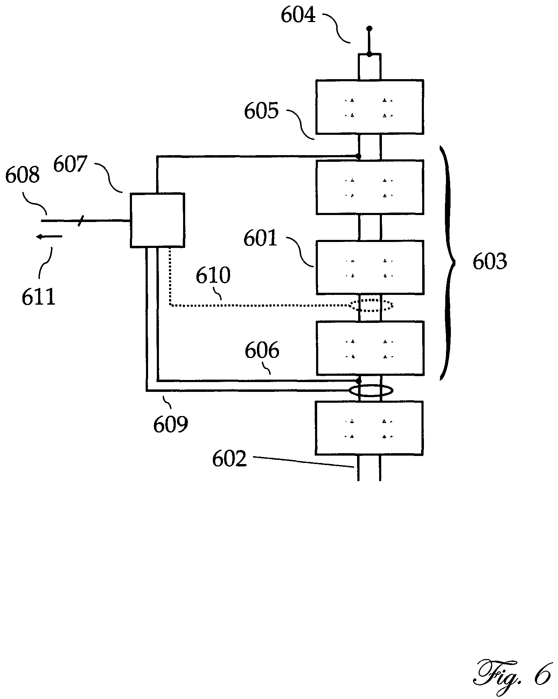

Figur 6 zeigt eine Ausführungsform der Erfindung, die zusätzlich zu der mindestens einen Spannungsmessung wie in Figur 4 auch mindestens eine Strommessung (609,610) beinhaltet. Die Strommessung kann dabei an einem oder mehreren beliebigen Orten erfolgen, angedeutet durch zwei Messstellen (609) und (610). Sind zwei Module durch mehr als eine elektrische Verbindungsleitung (602) verbunden, kann die Messung über einen Teil der Verbindungsleitungen (602) oder alle Verbindungsleitungen (602) erfolgen. Bei einem magnetischen Messsystem wird die Messschleife entsprechend um den gewählten Teil der Verbindungsleitungen (602) gelegt. Ist der betrachtete Modulstrang nicht verzweigt, sind alle Strommessstellen, beispielsweise (609) und (610) äquivalent. Die Strommessung wird von einem oder mehreren integrierten Schaltungen (607) erfasst und als analoges oder digitales Signal (608) an eine Steuerung oder einen Schätzer (611) ausgegeben. Die mindestens eine integrierte Schaltung (607) kann dieselbe sein, die die mindestens eine Spannungsmessung über die Messstellen (605, 606) durchführt oder getrennt sein. Ebenso kann das Signal (608) sowohl Spannungs- als auch Strominformationen enthalten oder nur eines davon und getrennte Signale für Spannungen und Ströme verwenden. Das Signal (608) kann auf einer oder mehreren physikalischen Leitungen übermittelt werden, die elektrisch, optisch, magnetisch oder mit anderen bekannten Übermittlungsmedien implementiert sind.

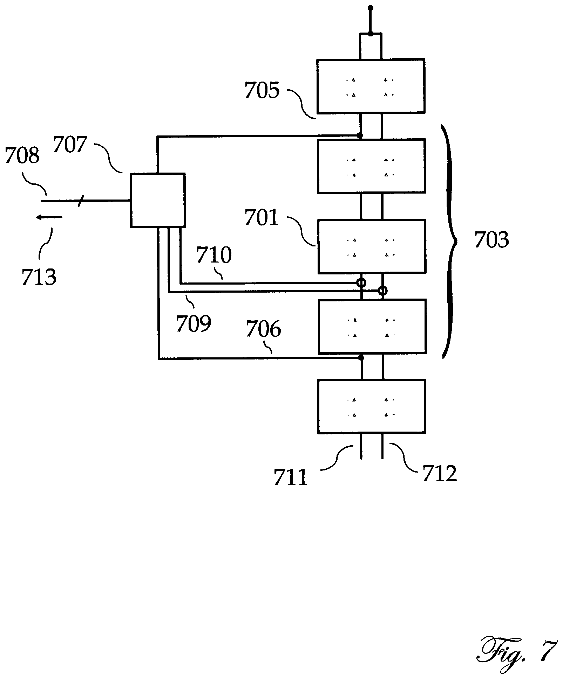

Figur 7 zeigt eine besondere Ausführungsform der Erfindung, in der Strommessungen (709) und (710) getrennt für die einzelnen Verbindungsleitungen (711) und (712) durchgeführt wird.

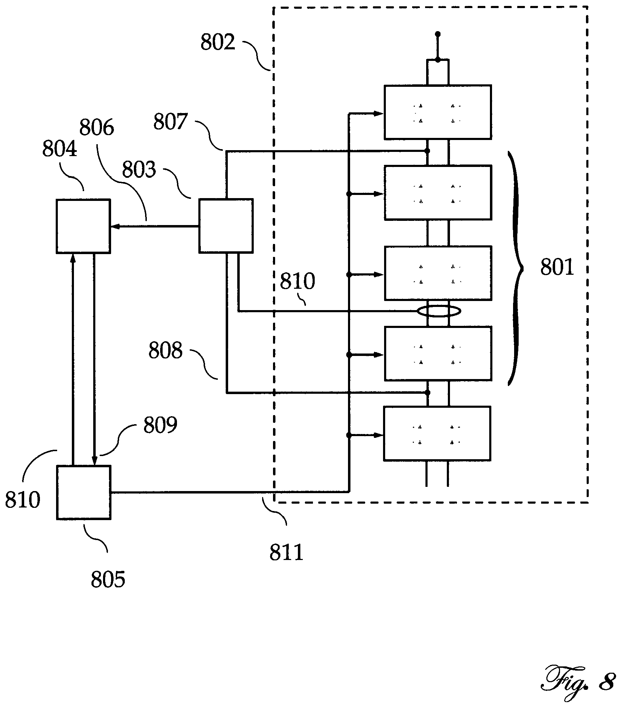

Figur 8 zeigt eine besondere Ausführungsform der Erfindung, die neben mindestens einer Spannungsmessung (807, 808) mindestens eine Strommessung (810) beinhaltet.

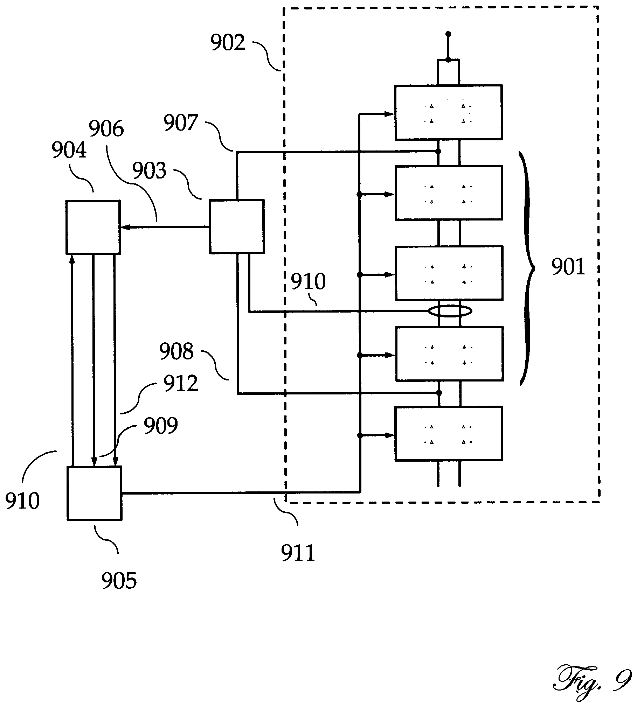

Figur 9 zeigt eine besondere Ausführungsform der Erfindung, die mindestens eine Spannungsmessung (907, 908), eine oder mehrere optionale Strommessungen (910) beinhaltet und bei der die integrierte Schaltung (904) neben Schätzwerten (909) beispielsweise der Modulspannungen auch zugehörige statistische Genauigkeitsmaße (912) an die integrierte Schaltung (905) überträgt, anhand derer die integrierte Schaltung (905) Informationen über die Genauigkeit und Zuverlässigkeit der Schätzwerte (909) erlangt und ggf. auch gezielt die neuen Modulzustände (911) in den folgenden Zeitintervallen so einstellt, dass die Genauigkeit einzelner oder bestimmter Schätzwerte, beispielsweise eines Moduls mit sehr ungenauer Modulspannungsschätzung, gezielt verbessert werden.

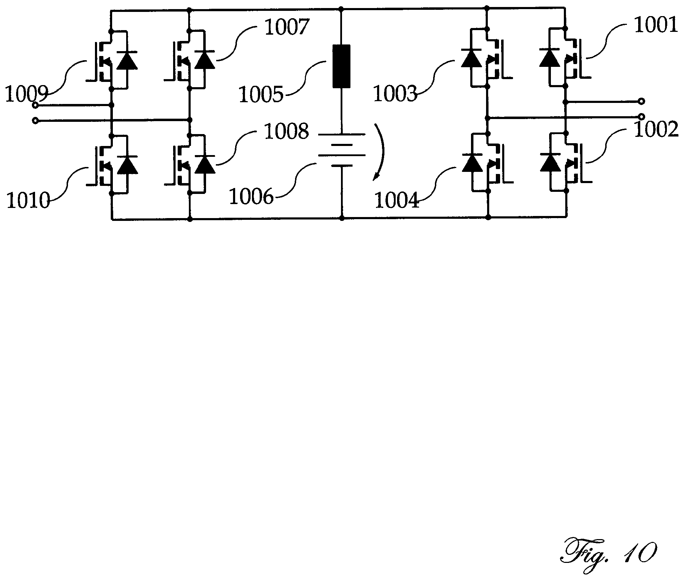

Figur 10 zeigt das von einer besonderen Ausführungsform der Erfindung angenommene Modell eines Moduls mit einem einfachen angenommenen Batteriemodell, das eine oder mehrere in Serie oder parallel geschaltete Batteriezellen als Energiespeicherelement darstellt, bestehend aus einer Spannungsquelle $V_m$ (1006) und einer Impedanz $X_a$ (1005). Ohne Einschränkung der Allgemeinheit ist hier ein M2SPC-Modul angenommen. Ebenso kann das Batteriemodell auch für andere Module verwendet werden.

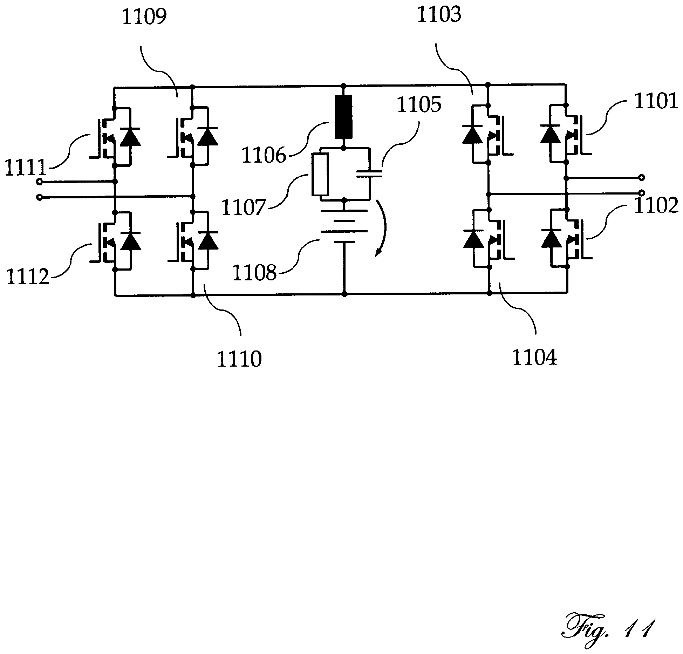

Figur 11 zeigt das von einer besonderen Ausführungsform der Erfindung angenommene Modell eines Moduls mit einem gegenüber Fig. 10 erweiterten Batteriemodell mit zusätzlichem Tiefpassverhalten gebildet durch einen Widerstand $R_b$ (1107) und einer Kapazität $C_b$ (1105). Ohne Einschränkung der Allgemeinheit wird als beispielhafter Modultyp ein M2SPC-Modul zur Darstellung verwendet.

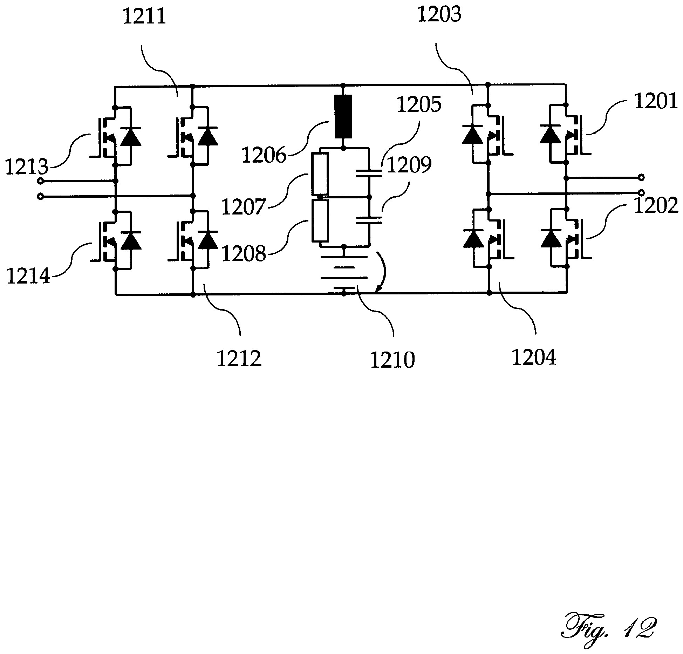

Figur 12 zeigt das von einer besonderen Ausführungsform der Erfindung angenommene Modell eines Moduls mit einem gegenüber Fig. 11 erweiterten Batteriemodell mit einem zweiten zusätzlichem Tiefpassverhalten bestehend aus einem Widerstand $R_c$ (1108) und einer Kapazität $C_c$ (1209) gebildet durch wird als beispielhafter Modultyp ein M2SPC-Modul zur Darstellung verwendet.

### Ausführliche Beschreibung der Erfindung und Ausführungsformen

Im Gegensatz zum Stand der Technik wird der Modulenergieinhalt nicht über eine Integration eines elektrischen Stromes ermittelt sondern über eine Spannungsmessung. In der einfachsten Ausführungsform der Erfindung wird die Gesamtspannung einer Einheit (unit) bestehend aus mehreren Modulen gemessen und auf dieser Basis die Modulspannungen geschätzt. Die Spannung wird folglich gemäß der Modulzustände, die die Konnektivität der Module beschreiben, auf die Einzelmodule aufgeteilt. Die Einheit aus mehreren Modulen kann der vollständige Umrichter sein oder auch nur ein Teil davon, beispielsweise ein Konverterarm oder ein Abschnitt eines Konverterarms.

Die Gesamtspannung $V_{unit}$ zu jedem Zeitpunkt t wird somit als Funktion $F$ der Modulzustände s und der (zu ermittelnden/schätzenden) Modulspannungen ausgedrückt, die invertiert werden muss:

$$V_{unit}(t) = F(s, V(i,t))$$

Die Schätzwerte für die Modulspannung werden hier äquivalent mit dem Energieinhalt verwendet, da hier davon ausgegangen wird, dass sich diese beiden Größen sehr genau ineinander umrechnen lassen.

Bei dieser vereinfachten Betrachtung ist der Zusammenhang zwischen den Modulspannungen und der Gesamtspannung der Einheit linear und lässt sich mit einer zu einem Zeilenvektor entarteten Matrix **M** darstellen, die diese Abbildung darstellt und deterministisch vom aktuellen Zustand aller Module s abhängt. Die Modulspannungen der Module $V(i,t)$ sind hier als Vektor **V(t)** zusammengefasst:

$$V_{\mathrm{unit}}(s(t)) = \mathbf{M}(s(t)) \cdot \mathbf{V}(t)$$

Die Abbildung, die durch die Matrix **M** dargestellt wird, liefert dabei in Abhängigkeit von den Modulzuständen s die Spannung als Ergebnis, die für bestimmte Modulspannungen die aktuell zu erwartende Ausgangsspannung der Einheit (unit) wäre. Für eine reine positive Serienschaltung aller Module enthielte die Matrix **M** zum Beispiel ausschließlich 1-Einträge; für eine reine negative Serienschaltung aller Module enthielte die Matrix **M** entsprechend nur -1-Einträge; sollten alle Module in einem Bypass-Zustand sein, wären alle Einträge der Matrix **M** entsprechend 0.

Wohl einer der Hauptgründe, warum diese Lösung nicht bisher vom Fachmann nicht erkannt wurde, ist, dass dieses Gleichungssystem selbst bei bekannter Matrix **M(s)** unterbestimmt ist und damit **V**(t) nicht aus $V_{\mathrm{unit}}$(t) eindeutig ermittelt werden kann. Dabei darf jedoch nicht ein Zeitschritt getrennt betrachtet werden. Ferner muss eine Reihe von Zeitpunkten zusammengefasst werden. $V_{\mathrm{unit}}$ wird dadurch zum Tensor 1. Stufe (Äquivalent zu einem Vektor) erweitert, M wächst zu einem Tensor 2. Stufe (Art Matrix-Äquivalent), ebenso ist V nun ein Tensor 2. Stufe (Art Matrix-Äquivalent) mit Modulen als ein Freiheitsgrad und Zeit als zweiten.

Da sich die Modulspannungen aufgrund der Modulspeicher nicht instantan ändern, können sie für eine gewisse Zeit vereinfachend als konstant betrachtet werden, um die Invertierung zu vereinfachen. Dadurch verändert sich lediglich V, da die Spalten als etwa gleich angesehen werden und daher nur als eine Mittelwertspalte verwendet werden. Sobald der Rang der erweiterten Matrix M die Anzahl der Spannungen in V erreicht, kann das Gleichungssystem systematisch eindeutig invertiert werden. Die Matrix enthält folglich eine vollständige Basis des Zustandsraumes der Einheit. Wenn der Rang niedriger ist, kann über bekannte Pseudo-Invertierungsverfahren eine Teil- oder Schätzlösung ermittelt werden. Überschreitet der Rang die Anzahl der Spannungen in **V,** kann eine mittelnde Ausgleichsrechnung durchgeführt werden, um Fehlereinflüsse beispielsweise durch Messungen zu minimieren. Ferner kann in diesem Fall eine sogenannte Kreuz-Validierung ausgeführt werden, indem das Gleichungssystem für alle erzeugbaren Teilmatrizen der Matrix **M** gelöst wird, die durch Eliminieren einzelner Zeilen der Matrix entstehen und vollen Rang haben. Die Einzelergebnisse können Mittelwert und andere statistische Eigenschaften wie beispielsweise Standardfehler, Standardabweichung und Verteilungsfunktionen liefern. Ferner kann für jedes Teilergebnis auf der Basis einer Teilmatrix genutzt werden, um diese in die jeweils für diese Teilmatrix eliminierte(n) Zeile(n) und deren zugehörige(n) eliminierte(n) Gleichung(en) einzusetzen und deren Abweichung zu quantifizieren.

In einer besonderen Ausführungsform der Erfindung übergibt die Schätzeinheit der Steuerungseinheit ein Signal mit Informationen über wünschenswerte Modulzustände zur Verringerung der Schätzunbestimmtheit beispielsweise einer oder mehrerer Spannungen von Modulenergiespeichern übergeben. In oben beschriebener Matrix-Vektor-Form entspricht dies beispielsweise entweder einem unterbestimmten Gleichungssystem (die Schätzunbestimmtheit für eine oder mehrere Spannungen sind somit theoretisch unendlich groß) oder im überbestimmten (rauschbehafteten) Gleichungssystem liegen nicht für alle Variablen gleich viele (partiell disjunkte) vollständige Teilgleichungssysteme vor, die jeweils zur Ausgleichsrechnung beispielsweise gemittelt werden können. Somit ist das Gleichungssystem nicht in allen Variablen gleichermaßen überbestimmt.

Die Bereitstellung eines solchen Signals kann einerseits in Form von Listen mit Zuständen, die bei Anwendung auf den Umrichter und anschließender Messung mit den wenigen noch notwendigen Sensoren wie oben beschrieben mit dem Beispiel der Matrix-Vektor-Gleichung von einer Unterbestimmtheit zu einem vollständigen Gleichungssystem oder ungleiche Überbestimmtheit in einzelnen Variablen ausgleichen können. Im Mixed-Model-Ansatz kann diese Liste Zustände enthalten, die bei Verwendung eine gleichmäßige Verringerung der Schätzunbestimmtheit (beispielsweise in Form von Standardfehler-, Standardabweichungs-, Entropiemaßen oder anderen statistischen, die Unschärfe einer Schätzverteilung quantisierenden Maßen) der einzelnen Schätzwerte herbeiwirkt. Dadurch kann die Steuerungseinheit innerhalb einer bestimmten vorgegebenen Zeit aus dieser Liste Zustände auswählen und einsetzen, die den übrigen Randbedingungen (beispielsweise Spannung an den Ausgängen oder Klemmen des Umrichters) am nächsten kommen.

Alternativ kann die Bereitstellung eines oben genannten Signals mit Informationen über wünschenswerte Modulzustände zur Verringerung der Schätzunbestimmtheit in Form einer nach Priorität geordneten Liste erfolgen.

Alternativ kann die Bereitstellung eines oben genannten Signals mit Informationen über wünschenswerte Modulzustände zur Verringerung der Schätzunbestimmtheit (auch Schätzunbestimmtheit) in Form einer Auflistung jedes zu ermittelnden Parameters (Schätzvariable), beispielsweise mit deren aktueller Schätzungenauigkeit, und für deren genauere Schätzung vorteilhafte Zuständen erfolgen. Zudem können zu jedem der vorgeschlagenen für eine genauere Schätzung vorteilhaften Zustände auch die jeweils zu erwartende Verringerung der Schätzungenauigkeit (beispielsweise als statistischer Erwartungswert) übermittelt werden. Im Falle einer online-Optimierung in der Steuerung, wie beispielsweise in Goetz et al. (2014) [Goetz, S. M. et al. (2014). Modular multilevel converter with series and parallel module connectivity: topology and control. IEEE Transactions on Power Electronics.] beschrieben, kann diese Information als zusätzliches Optimierungsziel und/oder Randbedingung zu anderen Optimierungszielen und Randbedingungen, beispielsweise Energieverluste, Ausgangsspannungen, Oberwellen etc., in die Regelungsstrategie integriert werden.

Die Ermittlung der Modulspannungen kann kontinuierlich während des gewöhnlichen Betriebs des Umrichters unter Last, d.h. für Ströme ungleich null durchgeführt werden. Wird diese Schätzung bei Strömen ungleich null durchgeführt, vernachlässigt der Ansatz Innenwiderstände. Wird diese Schätzung ferner bei zeitlichen Ableitungen des Stromes ungleich null durchgeführt, werden Induktivitäten vernachlässigt.

Bei sehr kompakten Aufbauten, die nur selten bei Spitzenlast betrieben werden oder aus anderen Gründen einen niedrigen Innenwiderstand und/oder parasitäre Induktivitäten aufweisen, ist dieses Vorgehen ausreichend. Ferner können sich Abweichungen aufgrund von vernachlässigten Innenwiderständen in vielen Fällen ausgleichen, insbesondere wenn ein Umrichter mit über Dauer mit einem Netto-Null-Energiefluss betrieben wird, folglich über lange Dauer sich die dem Umrichter entnommene Energie und die in den Umrichter eingespeiste Energie zu null addieren.

Alternativ können auch nur Messwerte einbezogen werden, zu welchen der Strom und/oder die Ableitung des Stromes zu null werden. Hierfür ist im Gegensatz zu einer vollständigen Überwachung der Module oder der Einheit keine exakte Messung von Strömen oder deren Ableitungen nötig. Stattdessen reichen einfache Schwellwertschalter aus, die deutlich kostengünstiger implementiert werden können und deren Signale deutlich einfacher für die Übertragung galvanisch getrennt werden können.

Ferner lassen sich auch in regelmäßigen Abständen Messungen mit vernachlässigbar geringem Strom und/oder Stromableitung durchführen. Separate Messsequenzen haben ferner den Vorteil, dass in einer kurzen Sequenz gezielt ganze Zustandsvektorraumbasen ausgegeben werden können und dabei nicht auf den Betriebspunkt des Umrichters Rücksicht genommen werden müssen. Auch Teile von Basen, um lediglich einige Modulspannungen zu bestimmen oder Durchschnittswerte zu ermitteln, sind möglich.

Diese regelmäßigen Messsequenzen können im Falle schneller Halbleiterbauelemente wie FET in der Größenordnung von Millisekunden durchführen. Dabei kann beispielsweise eine Elementarbasis des Zustandsvektorraums auf dem Umrichter erzeugt, und den zugehörigen stromlosen Ausgangsspannungsvektor $V_{unit}$ detektieren, um die lineare Abbildung vollständig zu analysieren und die aktuellen Modulspannungen zu ermitteln.

Um die natürlicher Verzögerung, bis die zu messende Spannung nach einer Zustandsänderung den Gleichgewichts- oder Endzustand erreicht, zu berücksichtigen kann eine gewisse *settling time* nach dem Einstellen eines jeden neuen Zustandes abgewartet werden, bis die eigentliche Messung beginnt. Ferner kann die Messung zur Erhöhung der Genauigkeit und Vermeidung von elektromagnetischem Rauschen über eine gewisse Integrationszeit hinweg mitteln.

Insbesondere in Kraftfahrzeugen liegen sehr häufig solche Pausen vor (Ampelphasen) oder können künstlich erzeugt werden (Leerlaufphase auf der Autbahn). Gleichzeitig sind bei Integration von Batterie und Umrichter in eine Einheit die Modulspeicherkapazitäten derart groß, dass keine durchgehende Vermessung notwendig ist, sondern eine regelmäßige Ermittlung ausreicht.

### Berücksichtigung der Belastung (Energieentnahme oder Energiezuführung)

Die Vernachlässigung des Lastzustandes und von Stromflüssen ist in einigen Fällen nachteilig und kann bei hohen Innenwiderständen und/oder Induktivitäten zu Abweichungen der Schätzung von den realen Werten führen. In diesem Fall kann das System um eine Strommessung erweitert werden. In diesem Fall wird zusätzlich zur Spannung $V_{unit}$ der Strom $I_{unit}$, der in die betrachtete Einheit (unit) hinein- oder hinausfließt, gemessen. Im Gegensatz zum Stand der Technik wird dieser Strom jedoch nicht zur Ermittlung einer Ladung herangezogen oder anderweitig einem Integratorbaustein (oder alternativ in Software durchgeführte Integration) übergeben.

Obige Grundgleichung kann entsprechend um einen Stromkorrekturterm erweitert werden. Für jedes Modul muss ein Innenwiderstand $R$ bekannt sein, der gegebenenfalls vom Zustand s des Moduls oder aller Module abhängen kann und ebenso dem Modul $i$ eigen sein kann, um beispielsweise Produktionstoleranzen und andere Modulunterschiede darzustellen. Ferner kann ein Widerstand $R_{rest}$ berücksichtigt werden, der keinem Modul zugeordnet werden kann.

$$V_{unit}(s(t)) + I_{unit}(R_{rest} + R(i,s(i))p(s)) = \mathbf{M}(s(t)) \cdot \mathbf{V}(t)$$

Sollen zudem auch (parasitäre) Induktivitäten in der Messvorrichtung/dem Umrichter eingeschlossen werden. Entsprechend wird ein weiterer Term mit einzelnen Modulinduktivitäten L und einem Restterm für Induktivitäten $L_{rest}$, die keinem Modul zugeordnet werden können, hinzugefügt. Die Lösung ist äquivalent.

$$V_{unit}(s(t)) + I_{unit}(R_{rest} + R(i,s(i))p(s)) + (L_{rest}\tfrac{d}{dt}I_{unit} + L(i,s(i))\tfrac{d}{dt}I_{unit}p(s)) = \mathbf{M}(s(t)) \cdot \mathbf{V}(t)$$

Ebenso wie oben beschrieben können diese Grundgleichungen für mehrere Zeitpunkte aufgestellt werden, um dann mit der Annahme, dass sich die Modulspannungen nur unwesentlich unterscheiden ein vollständig bestimmtes, ein überbestimmtes, oder auch ein noch unterbestimmtes Gleichungssystem zu erhalten.

**Messung und Ermittlung weiterer Eigenschaften**

In obigen Ausführungsformen der Erfindung müssen zentrale Eigenschaften des Umrichters und des Messsystems vorab bekannt sein, um ein Gleichungssystem aufstellen und lösen zu können. Darunter fallen beispielsweise die (optional zustandsabhängigen) Widerstände der Module, deren Induktivitäten, Restterme oder sogennannte Offsetterme, die keinem der Module oder Zustände zugeordnet werden können. Ferner könne mit obigem Ansatz über Matrix-Vektor-Gleichungssysteme keine komplexeren Abhängigkeiten einfach abgebildet werden.

Aus diesem Grund wird in einer besonderen Ausführungsform der Erfindung der Energieinhalt der Energiespeicher in den einzelnen Modulen mithilfe eines sogenannten *mixed model* oder *mixed effects model* ermittelt. In diesem Modell kann beispielsweise der Lastzustand sehr einfach eingeschlossen werden, eine Näherung für vernachlässigbaren Innenwiderstand findet nicht mehr statt.

$$V_{\text{unit}}(t) = V_{\text{offset}} + R_{\text{rest}}I_{\text{unit}} + \sum_{\text{Module } i} m(s)V(i,t) - R(i,s(i))I_{\text{unit}}p(s)$$

Die Gesamtspannung einer beliebigen Einheit, beispielsweise eines Konverterarms, $V_{\text{unit}}$ wird dabei aus der Summe eines optionalen Offsets $V_{\text{offset}}$, das Spannungsquellen, Materialübergänge (beispielsweise pn-Übergänge) mit deren inhärenten Spannungsstufen oder geladene Speicher außerhalb von Modulen umfassen kann, und ebenso optionalen Innenwiderständen $R_{\text{rest}}$, die nicht einem Modul zugeordnet sind, sowie einem Summenterm, der alle Module diese Einheit umfasst. Die beiden erstgenannten Restterme außerhalb der Modulstruktur stellen den offset-Faktor des *mixed models* dar, der deutsch auch als Achsenabschnitt bezeichnet werden kann.

Der Summenterm beinhaltet die (zu ermittelnde) Modulspannung $V(i,t)$, die vom Modul (i) sowie der Zeit (t) abhängt und mit einem Faktor m multiplizier

| | |
|---|---|
| $V_{\text{unit}}$ | Gesamtspannung der beliebigen Einheit; kontinuierliche Variable, gemessen |
| $V_{\text{offset}}$ | gemessen oder geschätzt; kontinuierliche Variable |
| $R_{\text{rest}}$ | Innenwidestand, der keinem Modul zugeordnet werden kann; kontinuierliche Variable; gemessen, bekannt oder geschätzt |
| $I_{\text{unit}}$ | In die beliebige Einheit einfließender Strom; gemessen oder festgelegt |
| t | Zeit, im Allgemeinen kontinuierlich, in diesem Modell der Einfachheit halber jedoch quantisierte, ordinale unabhängige Variable |
| i | Modul-Identifier; in der Regel nominale Variable, folglich ungeordnet; in der Regel endlich; es kann jedoch auch eine geordnete Abzählung verwendet werden, wobei numerisch benachbarte Modul-Identifier *i* beispielsweise Nachbarschaft der Module *i* in einer Modulkette, beispielsweise eines Konverterarms des M2C oder M2SPC, darstellen können. |
| s | Modulzustand, abhängig vom Modul; deterministische Variable des Modells, beschreibt den Zustand der Einheit und ist der oder den Regeleinheiten bekannt, nichtkontinuierliche, nominale Variable; zumeist endlich |
| m | modultypabhängiger deterministischer Faktor, der Modulzustände in einen Faktor umsetzt, der beschreibt, wie die Modulspannung zur Gesamtspannung beiträgt; für den seriell positiven Modulzustand des Moduls i ist m für Modul i beispielsweise +1, für bypass 0, für den parallelen Zustand hängt m vom Zustand s weiterer Module ab; aus diesem Grund kann dieser Faktor ggf. nicht nur vom Zustand s(i) des zugehörigen Moduls i, sondern von allen Modulzuständen s der Einheit abhängen; die Umsetzungstabelle kann entweder oder sogar über eine längere Laufzeit trainiert, das heißt als abhängige Variable geschätzt werden. |
| V | Modulspannung, d.h. die Spannung des modulintegrierten elektrischen Speichers; von der Zeit t und dem Modul abhängig; kontinuierliche abhängige Variable, wird geschätzt |
| R | Innenwiderstand eines Moduls; diese kontinuierliche Variable kann bekannt sein, beispielsweise vorab gemessen, oder aber auch als abhängige Variable im Betrieb geschätzt werden; R hängt in der Regel vom Schaltzustand s der Module ab; eine Abhängigkeit vom Modul kann vorteilhaft sein, um beispielsweise Produktionstoleranzen oder unterschiedlich starke Alterung zwischen Modulen besser beschreiben zu können, ist aber optional |
| p | analog dem Faktor m, der den zustandsabhängigen Beitrag eines Einzelmoduls an der Gesamtspannung der Einheit beschrieb, bildet der deterministische Faktor p ab, wie sich der Strom beispielsweise bei vorhandener paralleler Modulkonnektivität aufteilt; in der Regel sind m und p, beispielsweise p = 1/m |
| s | Der Modulzustand s(i) eines Moduls i und die Modulzustände mehrerer Module $\mathbf{s} = \{s_j\}$ sind bekannt und werden in der Regel von einer oder mehreren Regeleinheiten erzeugt, um die Regelziele des Systems zu |

erfüllen.

Die Schätzfaktoren V(t), R(i,s(i)) können dabei stochastische Anteile enthalten. Ferner können die stochastischen Anteile entweder mit angenommener parametrischer Verteilung (beispielsweise Gauß-Verteilung) oder nichtparametrisch mitsamt ihrer Verteilungsfunktion geschätzt werden.

In einer besonderen Ausführungsform werden ebenfalls (vor allem parasitäre) Induktivitäten eingeschlossen:

$$V_{\text{unit}}(t) = V_{\text{offset}} + R_{\text{rest}} I_{\text{unit}} + L_{\text{rest}} \tfrac{\mathrm{d}}{\mathrm{d}t} I_{\text{unit}} + \sum_{\text{Module } i} m(s)V(i,t) - R(i,s(i))I_{\text{unit}}\,p(s) + L(i,s(i))\tfrac{\mathrm{d}}{\mathrm{d}t}I_{\text{unit}}\,p(s)$$

Die Induktivitäten *L* der Module werden dabei äquivalent zum Innenwiderstand zuvor modelliert und können entweder als bekannte Parameter aufgefasst werden, beispielsweise aus separaten Messungen, oder im Betrieb mitgeschätzt werden. Ebenso kann ein optionaler offset-Term $L_{\text{rest}}$ vorgesehen werden.

Das gezeigte lineare Modell kann ferner beliebig erweitert werden, indem zusätzliche Terme hinzugefügt oder in die bestehenden Faktoren Abhängigkeiten zu bestehenden oder neuen Variablen eingeführt werden. Dabei bleibt jedoch ein Mindestkern wie oben beschrieben, bestehen, der nicht entfernt wird. Ferner können auch Terme entfernt werden, um das Modell und die Schätzung zu vereinfachen. Schrittweise lässt sich dieses Modell konsistent bis zur eingangs gezeigten linearen Matrix-Vektor-Gleichung $V_{\text{unit}} = \mathbf{M}\,\mathbf{V}$ vereinfachen. Somit lässt sich auch dieses einfachste Modell und alle Zwischenstufen über diesen Mixed-Modell-Ansatz lösen.

Ferner können neben der gemessenen Spannung der Einheit (unit) weitere Messwerte hinzugefügt werden, um die Schätzung genauer und/oder (mess-)fehlerunabhängiger zu gestalten und/oder die Möglichkeit zur Detektion von technischen Defekten des Umrichters zu gewinnen. Zu solchen Parametern gehört beispielsweise der in die Einheit hineinfließende Strom. Ferner können auch die Modulspannungen einzelner Module gemessen werden, um die Gesamtschätzung zu evaluieren oder genauer zu gestalten. Mit einer Cross-Validation kann auch beides zugleich durchgeführt werden. Die Messung diese einzelnen Modulspannungen kann mit deutlich niedrigerer Frequenz erfolgen als das Schätzungsintervall.

In einer besonderen Ausführungsform wird anstatt des einfachen linearen Modells der oben gezeigten Gleichungen eine Schaltungssimulation durchgeführt, um auf der Basis mindestens der Spannung der Einheit von einem oder mehreren Modulen und der Modulzustände der entsprechenden Module Modulspannungen zu schätzen. Während der Mixed-Model-Ansatz, beispielsweise in letztgenanner Gleichung, auch ohne genauere Kenntnis der implementierten elektrischen Schaltung in jedem einzelnen Modul durchgeführt werden kann, wenn lediglich die aus der Außenperspektive wichtigen elektrischen Variable, insbesondere die Spannung, ferner beispielsweise der Innenwiderstand und weitere oben genannte Variable, in Abhängigkeit vom Modulzustand geschätzt werden, kann eine Schaltungssimulation mit einem parametrischen Modell der exakten Schaltung auch Eigenschaften einzelner elektrischer Komponenten ermitteln. Zu diesem Zweck kann ein lineares oder nichtlineares Modell der Schaltung in einem traditionellen Schaltungssimulationsystem, beispielsweise basierend auf dem weit verbreiteten Spice-System, gelöst werden, wobei ein zusätzliches Optimierungssystem die Parameter so ermittelt, dass die Schaltung ein möglichst ähnliches Verhalten zu den Messwerten zeigt. Die Ähnlichkeit der in der Simulation geschätzten gegenüber den gemessenen Werten, beispielsweise der Gesamtspannung der Einheit aus einem oder mehreren Modulen und/oder dem Strom und/oder weiteren Messwerten, kann beispielsweise über die Summe der quadratischen Differenz definiert werden. Als Optimierungssystem können typische bekannte globale Optimierungsverfahren, beispielsweise Particle-Swarm-Optimierung, Evolutionary-Algorithms oder Simulated-Annealing, bekannte lokale Optimierungsverfahren, beispielsweise das Simplex-Verfahren, und hybride Verfahren, die beides vereinigen, implementiert werden.

In einer besonderen Ausführungsform stellt die Schätzung der Steuerung des Umrichters nicht nur geschätzte Daten zur Verfügung sondern beeinflusst auch die Modulzustände in der Zukunft derart, dass die Schätzung genauere Ergebnisse liefert oder einzelne Module besonders betont. In einer Listen-basierten Regelung, wie sie beispielsweise von Lesnicar et al. (2003) [A. Lesnicar and R. Marquardt (2003). An innovative modular multilevel converter topology suitable for a wide power range. IEEE Power Tech Conference Proceedings, 2003(3):6] oder auch Goetz et al. [Goetz, S. M. et al. (2014). Modular multilevel converter with series and parallel module Connectivity: topology and control. IEEE Transactions on Power Electronics.] beschrieben wird, kann dabei als alternatives oder zusätzliches Auswahlkriterium für das nächste vom Umrichter auszuführende Zustandsmuster eines verwendet werden, dass solche Zustandsmuster bevorzugt, die mit jenen der jüngsten Vergangenheit nicht oder am wenigsten linear abhängig ist. Dies kann beispielsweise über die Bildung des Skalarproduktes mit allen bisherigen Bitmustern und deren Summation erfolgen. Ferner kann eine Gewichtung mit der Vergangenheit einbezogen werden, beispielsweise Bei einer optimierenden Regelung, die mit Regelzielen arbeitet, kann ein zusätzliches Regelziel zu einer konkurrierenden Regelung hinzugefügt werden. Beispielsweise kann als Optimierungsziel ein Genauigkeitsmaß der Schätzung ($R^2$, Likelihood, Restvarianz ebenso wie alle bereits in diesem Text genannten) zur Minimierung verwendet werden. Sofern nicht ein gesamtes Genauigkeitsmaß sondern mehrere zur Verfügung stehen, beispielsweise für jeden Parameter, kann eine arithmetische Kombination, beispielsweise eine p-Norm dieser verwendet werden. Wird eine p-unendlich-Norm angewendet, entspricht dies dem der Genauigkeit des am ungenauesten geschätzten Parameters. In allen Fällen wird automatisch die Schätzung der Parameter sukzessive verbessert.

In einer besonderen Ausführungsform analysiert eine Regeleinheit die Veränderung der Werte einzelner oder aller Schätzvariablen, beispielsweise der Modulspannungen, über die Zeit $t$ hin und löst bei unwahrscheinlichen Ereignissen eine Warnung eines Operators oder eine automatische Überprüfung aus, mit der mögliche Fehler in der Schätzung evaluiert werden, damit nicht die Regelungseinheit für den nächsten Regelungsschritt unvorteilhafte oder gefährliche Entscheidungen auf der Basis eines potentiell falschen Schätzergebnisses trifft. Solche unwahrscheinlichen Ereignisse sind beispielsweise sehr schnelle Anstiege oder Abfälle einer Modulspannung, obwohl eine beträchtliche Speicherkapazität, beispielsweise Kondensatoren oder Batterien, in einem Modul. Derartige Informationen können ebenso für eine Detektion möglicher Alterungsprozesse oder Modulausfälle herangezogen werden. Dabei können beispielsweise Änderungen in bestimmte Richtungen (positiv oder negativ) und/oder Änderungen, die einen bestimmten Schwellenwert übersteigen, ein Signal auslösen, das angibt, dass eine Degradation oder Alterung entdeckt wurde.

In einer besonderen Ausführungsform wird gleichzeitig die jeweilige Modulspannung auf der Basis des Modulstromes über Integration der Kondensatorgleichung geschätzt. Der Modulstrom kann entweder gemessen oder aus dem Gesamtstrom der Einheit $I_{unit}$ bestimmt werden. Damit ähnelt diese Ausführungsform dem im Stand der Technik beschriebenen Lösungsansatz von Änquist et al. (2011). Jedoch wird diese alternative Schätzung nicht für die weitere Regelung des Systems sondern lediglich als Kontrolle, um entweder eine Warnung für den Operator oder eine automatische Überprüfung auszulösen oder dem Ergebnis der Hauptlösung eine Zuverlässigkeitsbeurteilung (beispielsweise ein oder mehrere sogenannte Soft-bits oder ein Reliability measure) zuzuordnen. Ferner können nun potentielle Offsets in der Strommessung erkannt werden, wenn diese alternative, auf der Integration des Modulstroms basierende Lösung kontinuierlich gegenüber der Hauptlösung wegdriftet.

In einer besonderen Ausführungsform werden einigen oder allen Schätzvariablen zusätzlich Zuverlässigkeitsmaße zugeordnet, die aus der Schätzung des *mixed models* entstammen. Im Falle eines least-squares-Schätzers kann dieses Maß aus dem (potentiell quadratischen) Residuen oder der nicht durch das Modell erklärbaren Variabilität ermittelt werden. Ein Likelihood-Schätzer kann ferner über die Fisher Information ein formales Zuverlässigkeitsmaß für jeden Schätzwert bereitstellen. Bei Bayes'schen Schätzern kann ein Zuverlässigkeitsmaß für jeden Schätzwert aus der a-posteriori-Wahrscheinlichkeitsverteilung der Schätzwerte entnommen werden, beispielsweise das zweite Moment der Verteilung hinsichtlich des entsprechenden Schätzwertes. Ferner können für alle Schätzwerte Jacobi-Matrizen (Summe aller Funktionalableitungen) der Sensitivität nach bekannten Verfahren berechnet werden, die angeben, wie sensitiv die Ergebnisse von einzelnen Messwerten abhängen. Eine hohe Sensitivität ist dabei ein Anzeichen für eine hohe Anfälligkeit gegenüber Ausreißern.

In einer besonderen Ausführungsform werden die geschätzten Innenwiderstandswerte der Module auf Schätzänderungen überwacht (sichtbar in einer langsamen Drift der Schätzwerte über die Zeit) oder beispielsweise regelmäßig zurückgesetzt und neu geschätzt, um Veränderungen zu detektieren. Eine starke Erhöhung kann auf einen nahen Ausfall eines Moduls, eines Halbleiters oder eines Speichers schließen lassen. Eine weitere Analyse, das heißt Ermittlung der genauen Zustandsabhängigkeit der Widerstandsabhängigkeit in diesem Modul, kann ggf. ein genaues Zuordnen des Fehlers zu einzelnen Komponenten in einem Modul zulassen. Als Beispiel kann eine Widerstandserhöhung, die nicht in einem Bypasszustand, aber in allen anderen Zuständen auftritt, mit hoher Wahrscheinlichkeit einem Speicher zugeordnet werden. Ähnliche Zuordnungen sind - abhängig von der verwendeten Umrichterschaltung - auch für einzelne Schalter möglich.

In einer besonderen Ausführungsform der Erfindung werden Energieverluste in den Energiespeichern der Module durch sogenanntes Lecken berücksichtigt. Dabei fließt ein ggf. Modulspannungsabhängiger Leckstrom (oft auch Blindstrom genannt), der den geladenen Speicher entleert. Ein solcher Strom kann beispielsweise ein Reststrom durch den Isolator eines Kondensators sein. In dieser Ausführungsform kann ein solcher Leckstrom beispielsweise durch Abziehen eines bekannten zeitabhängigen Spannungsverlustes einbezogen werden.

Alternativ kann der Leckstrom auch durch die Messung ermittelt und geschätzt werden. Dieser Leckstrom kann modulabhängig und auch Zustandsabhängig sein. Ferner kann der Leckstrom alterungsbedingt sein und sich aus diesem Grund im Laufe der Lebensdauer des Umrichters verändern.

In einer besonderen Ausführungsform wird der Modulinnenwiderstand $R$ eines jeden Moduls, sofern er je Modul $i$ nur als Widerstand in Abhängigkeit vom Modulzustand $s(i)$ als $R(i, s(i))$ vorliegt, mithilfe des Wissens über die in den Modulen implementierten elektrischen Schaltungen auf einzelne elektrische Schaltungskomponenten in der Schaltung aufgeteilt. Bei Berücksichtigung des Strompfades für den jeweiligen Zustand können die elektrischen Schaltungskomponenten ermittelt werden, die im jeweiligen Zustand zum Innenwiderstand beitragen. Dadurch dass in der Regel zwar in jedem Zustand mehrere elektrische Schaltungskomponenten zum Innenwiderstand beitragen, aber nicht in jedem Zustand dieselbe (Linear-)Kombination aus Schaltungskomponenten, kann auch rechnerisch auf einzelne Komponenten geschlossen werden.

Beispielsweise wird der Innenwiderstand in einem konventionellen M2C-Vierquadrantenmodul im Bypass-Zustand von den beiden unteren Transistoren, im positiven Zustand vom linken unteren und dem rechten oberen Transistor und dem Speicher, im negativen Zustand vom linken oberen und dem rechten unteren Transistor und dem Speicher verursacht. Steigt der Modulinnenwiderstand beispielsweise nur im positiven Zustand an, aber in keinem anderen, kann eine Degradation des Energiespeichers des Moduls mit hoher Wahrscheinlichkeit ausgeschlossen werden, da dieser auch im negativen Zustand verwendet wird, und der Fehler ist mit hoher Wahrscheinlichkeit im rechten oberen Transistor zu finden, da die unteren Transistoren auch im Bypass-Modus verwendet werden, der nicht beeinträchtig ist.

Für andere Module lassen sich ähnliche Abhängigkeiten aufführen. Damit lassen sich der Widerstand R und Veränderungen dessen entweder einzelnen oder einer Gruppe mehrerer elektrischer Schaltungskomponenten zuordnen. Dies hat den Vorteil, dass beispielsweise Degradationen auf auslösende, betroffene Schaltungskomponenten oder auf eine Gruppe von betroffenen Schaltungskomponenten zurückgeführt werden können. Diese besondere Ausführungsform führt eine derartige Zuordnung durch und gibt das Ergebnis an die Steuerung und/oder eine Anzeige und/oder eine Protokollierungseinheit als Signal weiter, um einerseits beispielsweise den Nutzer oder Techniker für die Reparatur oder Wartung zu informieren und andererseits, und deutlich wichtiger, diese Information in der Regelung hinsichtlich der zukünftigen Modulnutzung zu berücksichtigen. Besonders vorteilhaft ist dabei einerseits den Einfluss erhöhter Innenwiderstände auf die Effizienz zu berücksichtigen und deshalb die Modulzustände mit erhöhtem Innenwiderstand beispielsweise insbesondere bei hohen Strömen aus Effizienzgründen zu meiden. Ferner kann die Regelung das Modul im allgemeinen weniger einsetzen, um eine gleichmäßige Alterung aller Module und/oder elektrischen Schaltungskomponenten zu erreichen.

In einer besonderen Ausführungsform beinhalten die Modulenergiespeicher mindestens eine Batteriezelle und die Leistungselektronik führt neben der Energiewandlung (beispielsweise zu einer Wechselspannung für einen Motor) auch das Batteriemanagement durch. Das heißt

Eine zusätzliche Messung von Zellspannungen oder Spannungen von einzelnen Batteriezellverbänden kann vollständig oder nahezu vollständig entfallen.

Ferner muss eine Reihe von Zeitpunkten zusammengefasst werden

In einer besonderen Ausführungsform werden zur Erreichung der Vollständigkeit oder Überbestimmtheit der Gleichungssysteme oder der Reduktion der Schätzunschärfe des Mixed-Modells nicht eine Reihe von Zeitpunkten, beispielsweise der Modulspeicherspannungen, ungewichtet zusammengefasst. Stattdessen wird entweder jedem Modulenergiespeicher eine individuelle Dynamik oder allen Modulspeichern gleichen Typs eine gemeinsame Dynamikgleichung zugeordnet, die selbst Schätzparameter enthält, aber ein

Beispiele für sind eine lineare Dynamik erster Ordnung wie beispielsweise die Kondensatorgleichung (Zeitableitung der Energiespeicherspannung = Konstante A $\times$ Strom + Konstante B). Ferner können nichtlineare Glieder hinzugefügt werden (Zeitableitung der Energiespeicherspannung = Konstante A $\times$ Strom + Konstante B + Konstante C $\times$ Quadrat des Stromes) oder die Konstanten vorgegebene Abhängigkeit von der Spannung und/oder der Ableitung der Spannung aufweisen. Die Konstanten können entweder vorgegeben oder im Schätzvorgang mit den übrigen Parametern geschätzt werden. Durch die Verwendung einer zeitabhängigen dynamischen Gleichung für die Spannungen der Modulenergiespeicher statt einer ungewichteten Zusammenfassung mehrerer Zeitpunkte wird der Fehler durch eine Entladung oder Aufladung verringert und stattdessen das Entlade- und Aufladeverhalten mit in das Modell integriert.

In allen Ausführungsformen kann die Schätzung in derselben oder denselben integrierten Schaltungen, beispielsweise Microcontrollern, Signalprozessoren, oder FPGAs implementiert sein, die auch die Steuerung des Systems durchführen. Ferner können auch beide in getrennten integrierten Schaltungen durchgeführt werden. Beide können in jeweils einzelnen zentralen integrierten Schaltungen oder in jeweils verteilten Schaltungen implementiert sein. Ferner kann ein Datenaustausch zwischen den getrennten integrierten Schaltungen stattfinden.

In einer besonderen Ausführungsform enthält der oben pauschal als $R$(i, s) dargestellte Innenwiderstand des Moduls i abhängig vom Zustand s ersetzt durch ein Netzwerk an Einzelwiderständen, die die im aktuellen Zustand s leitenden Modulkomponenten abbilden. Im einfachsten Fall wird jedem geschlossenen Schalter und dem Energiespeicher ein Innenwiderstand zugeordnet. Im einfachsten Fall sind diese Werte für Schaltungskomponenten gleichen Typs identisch angenommen und durch eine einzelne Variable beschrieben. Um Produktionstoleranzen und unterschiedliche Alterungsgeschwindigkeiten abbilden zu können auch individuelle Variable für einige oder jedes Element verwendet werden. Die Einzelwiderstände können dabei entweder bekannt sein und als unabhängige Variablen dienen oder in der Schätzung als abhängige Variablen geschätzt werden. Alternativ kann statt einer Zuordnung eines Innenwiderstandes zu jeder Schaltungskomponente kann auch ein Innenwiderstand des gesamten Moduls in Abhängigkeit vom Zustand s eines Moduls erfolgen. Dieser Innenwiderstand in Abhängigkeit vom Modulzustand kann sowohl geschätzt werden oder auch als bekannte Größe und somit während der Schätzung als Konstante verwendet werden. In dieser Vereinfachung mit einem Innenwiderstand je Modul in Abhängigkeit vom Modulzustand muss die genaue elektrische Schaltung in den Modulen nicht bekannt sein.

In einer besonderen Ausführungsform wird nicht ein einzelnes vorgegebenes Modell geschätzt, sondern es wird ein Optimum aus Flexibilität und Stabilität unter Berücksichtigung der vorhandenen Messwerte gefunden. Diese besondere Ausführungsform nutzt die oben bereits angesprochene Erweiterbarkeit des Modells aus, um ein Gleichgewicht zwischen dem sogenanntem high-variance- und high-bias- Zustand wie folgt zu finden:

Für die Schätzung, beispielsweise eines Mixed-Model, wurde bereits oben genannt, dass die zugrundeliegende Schätzgleichung beliebig erweitert werden kann. Eine solche erweiterung kann auf zweierlei Arten erfolgen:

(a) Neben den bereits oben dargestellten Abhängigkeiten können weitere, bislang überhaupt nicht in den Gleichungen des Modells berücksichtigte Einflussfaktoren als Abhängigkeiten eingeführt werden. Beispielsweise kann der Widerstand $R(i, s(i))$ im Modell ferner von der Temperatur $\vartheta$ und/oder der Zeit $t$ und/oder der Luftfeuchte $\varphi$ und/oder dem mechanischen Druck $p$ auf einen oder mehrere elektrische Komponenten der Schaltung und/oder andere Umgebungsparameter abhängig beschrieben werden. Diese Alternative bezeichnet folglich die Hinzunahme von weiteren, bislang nicht einbezogenen Externalitäten.

(b) Ferner können die Abhängigkeiten der bereits in der Gleichung vorhandenen Variablen untereinander erweitert werden. In Mixed-Models werden derartig erweiterte Abhängigkeiten einer oder mehrerer Variablen von anderen Variablen, die bereits in den Gleichungen des Modells vorhanden sind oft als Interaktion (Interaction) bezeichnet. Beispielsweise kann ein Widerstand nicht nur vom Modulzustand $s$ und ggf. individuell für ein Modul sein (und damit von $i$ abhängen) abhängen, sondern auch von der Modulspannung oder dem Strom oder anderen Variablem im System abhängen. Im Falle vollständiger Berücksichtigung aller dieser Interaktionen ist jede Variable von jeder anderen Variable abhängig.

Wie bei Mixed-Models üblich wird bei Abhängigkeit einer abhängigen Variable von nominalen Variablen für jeden möglichen Wert der nominalen Variable ein Wert für die davon abhängige Variable geschätzt. Bei Abhängigkeit der abhängigen Variablen von kontinuierlichen Variablen wird im einfachsten Fall in der Regel eine (affin) lineare Funktion angenommen. Ferner kann im Fall von Abhängigkeiten von kontinuierlichen Variablen die (affin) lineare Abhängigkeit von der kontinuierlichen Variable entweder durch eine logarithmische Abhängigkeit ersetzt werden oder durch höhere nichtlineare Terme einer Reihe (beispielsweise quadratische, kubische, quartische Abhängigkeiten von der kontinuierlichen Variable) erweitert werden.

Sei als Beispiel das Modell der letztgezeigten Gleichung genommen, liegen sechs deterministisch, d.h. bekannte ($s$, $V_{unit}$, $I_{unit}$, $p(s)$, $i$, $m$) und fünf unbekannte Werte ($V_{off}$, $R_{rest}$, $L_{rest}$, $V$, $L$) vor. Bei vollständiger Abhängigkeit jedes unbekannten Parameters von jedem anderen (bekannten und unbekannten) bis zur dritten Ordnung, liegen $5 \times [1 + 3 \times (6 + 5 - 1)] = 155$ Freiheitsgrade vor. Zwar stellte dieses Modell das genaueste und flexibelste Modell dar; für eine unzureichende Anzahl und/oder unzureichend gestreute Messwerte wird dieses Modell allerdings sehr einfach "überfittet". Die besondere Ausführungsform ermittelt das zu verwendende Modell dabei automatisch und sucht einen Ausgleich zwischen einem high-variance- und high-bias-Zustand. Die besondere Ausführungsform nimmt dazu

Dabei schätzt sie mehrere Modelle gleichzeitig und ermittelt für jedes Modell ein sogenanntes Goodness-of-Fit-Maß, wie sie in der Statistik bekannt sind. Darunter fallen beispielsweise die Bay-es'sche Information nach Schwarz, die Akaike Information, die Kulback-Leibler-Divergenz und Kreuz-Validierung (cross validation). Das Modell mit dem besten Goodness-of-Fit wird dabei als maßgebliches Modell verwendet. Da mit längerer Betriebsdauer die Zahl der verfügbaren Messwerte steigt und damit ein komplexeres Modell mit erweiterten Abhängigkeiten bessere Goodness-of-Fit haben könnte, kann ggf. in regelmäßigen Abständen das maßgebliche Modell (nach vorherigem Vergleich mehrerer Kandidaten auf der Basis der Goodness-of-Fit) gewechselt werden. Somit wählt diese besondere Ausführungsform selbst das zu verwendende Modell anhand lediglich anzugebender Grundzüge, beispielsweise einer Liste von Variablen und Parameters, aus der Verknüpfung aller zur Verfügung stehenden Variablen und Parameter bis zu einer bestimmten polynomischen Abhängigkeit aus. Da sich derartige mehrere Modelle mit unterschiedlicher Komplexität der Abhängigkeiten parallelisiert und vektoriell für die Schätzung lösen lassen, ist diese besondere Ausführungsform implementiert in integrierten Schaltungen überaus vorteilhaft.

In einer besonderen Ausführungsform wird jedes Modul durch ein Netzwerk aus Einzelwiderständen, die die im aktuellen Zustand $s$ leitenden Modulkomponenten, beispielsweise elektronische Schalter, abbilden und eine Spannungsquelle mit der Modulspannung $V(i)$ dargestellt. Die Spannungsquelle stellt den mindestens einen Energiespeicher des Moduls dar und kann ferner durch einen Innenwiderstand ergänzt werden.

In einer besonderen Ausführungsform ist der Innenwiderstand im Modell des Energiespeichers durch ein gängiges Batteriemodell dargestellt. Dieses Batteriemodell kann mindestens eine Batteriezelle als Energiespeicher mit der Spannung $V_m$ repräsentieren und beispielsweise eine Impedanz $X_a$ (siehe Fig. 10) enthalten, die sowohl einen reellen (Ohm'schen) als auch einen imaginären (reaktanten) Anteil enthalten kann. In vielen Fällen ist der imaginäre Anteil von $X_a$ als vernachlässigbar angenommen. Ferner kann neben $X_a$ ein oder mehrere RC-Glieder (siehe Fig. 11 und Fig. 12) enthalten. Die Zeitkonstanten der jeweiligen RC-Glieder sind in der Regel in der Größenordnung von $R_b C_b \sim (1 \times/\div 4)$ min und $R_c C_c \sim (2 \times/\div 4)$ ms, wobei $\times/\div$ für eine multiplikative Streuung steht. Die Parameter $V_m$, $X_a$, $C_b$, $R_c$ und $C_c$ können entweder alle geschätzt werden oder teilweise vorgegebenen sein. Ferner können diese Parameter teilweise zeitabhängig angenommen werden. Für die Spannung $V_m$ ist die Annahme einer Zeitabhängigkeit naheliegend.

In einer besonderen Ausführungsform werden ein oder mehrere Module als Norm oder Referenz zur Bestimmung der Spannungen der Energiespeicher der restlichen Module herangezogen. Hierzu erfolgt eine exakte Spannungsmessung der ein oder mehrere Module (entweder separat in jedem der ein oder mehreren Module oder als Summe über alle hinweg zusammen in einer Messung) und eine zusätzliche Messung entweder des Gesamtstromes oder des Vorzeichens des Gesamtstromes oder des Vorliegen eines vernachlässigbaren Stromes (beispielsweise als Statusbit 1, wenn der absolute Strom eine bestimmte Schwelle unterschreitet) oder der Summenspannung der zu vermessenden Module (beispielsweise 901) oder des Vorzeichens der Summenspannung der zu vermessenden Module (beispielsweise 901) oder des Vorliegens einer vernachlässigbaren Summenspannung der zu vermessenden Module (beispielsweise 901). In dieser besonderen Ausführungsform der Erfindung können auf der Basis der gemessenen Modulspannungen und der zusätzlichen Information über die Summenspannung der zu vermessenden Module oder des Stromflusses entweder ein Nullzustand entweder der Summenspannung der zu vermessenden Module oder des Stromflusses und so durch Erreichung eines vollständigen oder überbestimmten Gleichungssystems die übrigen Parameter bestimmt werden. Bei Vorliegen einer genauen Summenspannungsmessung der zu vermessenden Module anstatt nur einer Nulldurchgangsinformation von Strom oder Spannung können ferner äquivalent auch ohne Herbeiführung oder Abwarten ausreichend vieler unterschiedlicher Nullzustände für ein vollständiges oder überbestimmtes Gleichungssystem die übrigen Parameter bestimmt werden. Im Falle einer zusätzlichen Summenspannungsmessung der zu vermessenden Module oder des Nullzustandes der Summenspannung der zu vermessenden Module sind vorteilhafterweise einige oder alle der ein oder mehreren Referenzmodule Teil der zu vermessenden Module. Die ein oder mehreren Referenzmodule können auch Spannungsnormen sein, deren Spannung(en) bekannt ist/sind und deshalb nicht gemessen werden müssen. Beispielhafte Spannungsnormen sind Halbleiterübergänge, Somit lassen sich bei Einsatz dieser Spannungsnormen Vergleiche über eine Erzeugung eines Nullzustandes (Spannung oder Strom) mit allen möglichen Kombinationen von anderen Modulen oder der gemessenen Summenspannung anstellen, die eine Bestimmung der Spannung der zu vermessenden Module erlaubt.

In einer besonderen Ausführungsform umfasst die Erfindung eine Methode zum Steuern einer elektrischen Schaltung, die mindestens zwei untereinander ähnlichartige Module beinhaltet, die jeweils mindestens einen elektrischen Energiespeicher und mindestens einen elektronischen Schalter enthalten, der das Wechseln der Konnektivität, das heißt der elektrischen Verschaltung (beispielsweise parallel oder seriell) des mindestens einen elektrischen Energiespeichers mit den Energiespeichern anderer Module ermöglicht. Eine Berechnung ermöglicht, die Spannung der einzelnen Energiespeicher der Module einer Gruppe mehrerer Module aus Messwerten der von genannter Gruppe mehrerer Module erzeugten Spannung zu ermitteln. Eine Gruppe mehrerer Module enthält dabei mindestens zwei Module.

In einer besonderen Ausführungsform stellt oben genannte Berechnung die gemessenen Spannungen der Gruppe mehrerer Energiespeicher als mathematische Kombination der zu ermittelnden Spannungen der Energiespeicher der Module der Gruppe dar, wobei die mathematische Kombination durch die bei der Spannungsmessung vorliegenden Schaltzustände der Module der Gruppe definiert ist. Die Ermittlung der Spannungen der Energiespeicher der Module erfolgt durch Lösen der mathematischen Kombination in der Art, dass die ermittelten Spannungen der Energiespeicher der Module in der mathematischen Kombination die gemessenen Spannungen als mathematisches Ergebnis haben.

In einer besonderen Ausführungsform beinhaltet oben genannte mathematische Kombination neben den zu ermittelnden Spannungen der Energiespeicher der Gruppe von mehreren Modulen ferner mindestens zwei Messwerte des durch einen Teil der Gruppe oder die gesamte Gruppe von mehreren Modulen fließenden Stromes, die in unterschiedlichen Schaltzuständen der Module gemessen wurden.

In einer besonderen Ausführungsform wird neben einem elektrischen Modell auch ein thermisches Modell geschätzt. Das elektrische und das thermische Modell sind dabei über elektrische Parameter gekoppelt, insbesondere den Strom. Die Temperaturen einzelner Komponenten, beispielsweise Speicherzellen, Halbleiter, etc. können dabei entweder geschätzt werden, um der Steuerung des Umrichters für die Entscheidung der Steuerung in der Zukunft zur Verfügung zu stehen, beispielsweise der Lastverringerung heißer Module etc. Ferner können diese auch (zum Teil) gemessen werden, um die Schätzung von anderen Variablen zu ermöglichen oder vereinfachen, beispielsweise thermischen Widerständen.

Ebenso kann die Außentemperatur als Variable in das Modell eingefügt werden und entweder gemessen oder geschätzt werden.

Folgendes Modell stellt Temperatur $\vartheta$ je Modul in Abhängigkeit von elektrischen Bedingungen dar.

$$c_{\text{therm}}(i)(\vartheta(i) - \vartheta_{\text{Umgebung}}) = R(i, s(i))(I_{\text{unit}}\, p(\text{s}))^2$$

Die thermische Kapazität $c_{\text{term}}$ ist dabei eine kontinuierliche Variable, die entweder geschätzt oder vorgegeben werden kann. Die Umgebungstemperatur $\vartheta_{\text{Umgebung}}$ kann gemessen, festgelegt (wobei auch der Wert 0 also eine Eliminierung eine gerechtfertigte Festlegung ist) oder geschätzt werden. Die Kopplung von thermischer und elektrischer Domäne erfolgt hier sowohl über den elektrischen Widerstand R als auch den Strom $I_{unit}p$(s). Alternativ kann auch lediglich eine Kopplung über den Strom erfolgen und ein getrennter elektrischer Widerstand $R$ verwendet werden, der entweder geschätzt oder vorgegeben wird.

Alternativ kann die Temperatur auch für Teile eines Moduls, beispielsweise bestimmte Halbleiter oder einen oder mehrere Speicher, getrennt bestimmt werden. Das Schätzmodell ist entsprechend anzugleichen.

**Patentansprüche**

1. Elektrische Schaltung, die mindestens zwei untereinander ähnlichartige Module (401) beinhaltet, die jeweils mindestens einen elektrischen Energiespeicher und mindestens einen elektronischen Schalter enthalten, der das Wechseln einer elektrischen Verschaltung des mindestens einen elektrischen Energiespeichers mit den Energiespeichern anderer Module ermöglicht,

   wobei die elektrische Schaltung weiter mindestens eine Spannungsmesseinrichtung (407) beinhaltet, die dazu ausgelegt ist, von einer Gruppe (403) von mehreren Modulen zusammen erzeugte elektrische Spannungen in mindestens zwei unterschiedlichen Schaltzuständen der Module zu messen und eine automatische Ermittlung der Spannungen der elektrischen Energiespeicher der einzelnen Module durchzuführen,

   wobei die mindestens zwei Module als ähnlichartig gelten, wenn diese mindestens zwei gleiche Schaltzustände darstellen können, die jeweils definieren, wie der jeweilige Energiespeicher mit den Energiespeichern der anderen Module elektrisch leitend verbunden ist, wobei die Gruppe von Modulen mindestens zwei Module der Schaltung umfasst,

   **dadurch gekennzeichnet, dass** die elektrische Schaltung dazu ausgelegt ist, die zu ermittelnden Spannungen V(i, t) der elektrischen Energiespeicher der einzelnen Module i als Koordinaten in einem Vektor **V**(t) zusammenzufassen und zu einem jeweiligen Zeitpunkt t und bei einem entsprechend aktuellen in einer Matrix **M**(s(t)) dargestellten Schaltzustand s(t) der Module zu dem jeweiligen Zeitpunkt t auf eine von der Gruppe (403) der Module i zusammen aktuell erzeugte elektrische Spannung $V_{unit}$(s(t)) abzubilden und durch Auflösung nach **V**(t) zu bestimmen:

   $$V_{unit}(s(t)) = \mathbf{M}(s(t))\, \mathbf{V}(t),$$

   wobei die elektrische Schaltung weiterhin dazu ausgelegt ist, beim Bestimmen der Spannungen anzunehmen, dass sich die jeweiligen Spannungen der elektrischen Energiespeicher der einzelnen Module zu den verschiedenen Zeitpunkten nur unwesentlich ändern, und eine Reihe von verschiedenen Zeitpunkten t derart zusammenzufassen, dass die zu bestimmenden Spannungen für diese Zeit als konstant betrachtet werden.

2. Schaltung nach Anspruch 1, wobei die mindestens zwei Module als untereinander ähnlichartig gelten, wenn diese mindestens zwei der folgenden drei Schaltzustände darstellen können:

   der mindestens eine elektrische Energiespeicher eines Moduls wird mithilfe von elektrischen Schaltern mit dem mindestens einen Energiespeicher eines weiteren Moduls in Serie geschaltet;

   der mindestens eine elektrische Energiespeicher eines Moduls wird mithilfe von elektrischen Schaltern mit dem mindestens einen Energiespeicher eines weiteren Moduls parallel geschaltet;

   der mindestens eine elektrische Energiespeicher eines Moduls wird mithilfe von elektrischen Schaltern gebypasst, was bedeutet, dass der mindestens eine elektrische Energiespeicher eines Moduls nur mit maximal einem seiner mindestens zwei elektrischen Kontakte mit einem elektrischen Energiespeicher eines weiteren Moduls elektrisch leitend verbunden ist und somit kein geschlossener Stromkreis mit einem elektrischen Energiespeicher eines weiteren Moduls vorliegt.

3. Schaltung nach einem der Ansprüche I oder 2, wobei die Ermittlung der Spannungen der elektrischen Energiespeicher mindestens zweier Module in mindestens einer Schätzeinheit (504) erfolgt, die mindestens eine integrierte elektronische Schaltung umfasst.

4. Schaltung nach Anspruch 3, wobei die mindestens eine Schätzeinheit (504) als Eingangssignale mindestens ein digitalisiertes Messsignal (506) der von einer Gruppe mehrerer Module erzeugten elektrischen Spannung von einer Messeinheit erhält und von mindestens einer Steuereinheit mindestens ein die aktuellen Modulzustände beschreibendes Signal (510) erhält.

5. Schaltung nach Anspruch 4, wobei die Schätzung gemäß eines digitalen Taktes in festen Zeitschritten erfolgt.

6. Schaltung nach Anspruch 5, wobei die Schätzeinheit mindestens einen digitalen Speicherbaustein enthält, der mindestens die Modulzustände und die Messwerte der erzeugten elektrischen Spannungen einer Gruppe mehrerer Module mehrerer vergangener digitaler Takte speichert.

7. Schaltung nach einem der Ansprüche 4 bis 6, wobei die Schätzeinheit der Steuereinheit (505) mindestens ein die geschätzten Modulspannungen der einzelnen Module beschreibendes Signal (509) übermittelt.

8. Schaltung aus einem der Ansprüche 1 bis 7, wobei die Vorrichtung neben der Spannung auch den in die Gruppe (403) mehrerer Module einfließenden elektrischen Strom misst und für die automatische Ermittlung der Modulspannungen der einzelnen Module heranzieht.

9. Schaltung aus einem der Ansprüche 1 bis 8, wobei die Vorrichtung ferner mindestens zwei Spannungsmesseinrichtungen umfasst, von welchen jede die von einer jeweils zugehörigen Gruppe (403) von mehreren Modulen zusammen erzeugten elektrischen Spannungen in mindestens zwei unterschiedlichen Schaltzuständen der Module misst, wobei einzelne Module Teil mehrerer der genannten je mindestens einer Spannungsmesseinrichtung zugehörigen Gruppen sind; und wobei mit den mindestens zwei Spannungsmesseinrichtungen ein Schätzfehler der ermittelten Spannungen der elektrischen Energiespeicher der einzelnen Module ermittelt wird und/oder eine Detektion eines technischen Ausfalls von mindestens einer der mindestens zwei Spannungsmesseinrichtungen durchgeführt wird.

10. Schaltung nach einem der Ansprüche 1-9, wobei die Vorrichtung ferner mindestens eine Temperaturmesseinrichtung beinhaltet, die die Temperatur eines Moduls (401) oder mindestens eines elektronischen Schalters eines Moduls (401) oder mindestens eines elektrischen Energiespeichers eines Moduls (401) oder einer Gruppe (403) von mehreren Modulen misst.

11. Verfahren zur Ermittlung von jeweiligen Spannungen einer Mehrzahl von elektrischen Energiespeichern, wobei jeweils mindestens eine elektrische Verbindung zwischen den einzelnen Energiespeichern durch jeweils mindestens ein elektrisches Schaltelement voneinander getrennt ist und wobei die Mehrzahl von elektrischen Energiespeichern und trennenden elektrischen Schaltelementen Teil einer modularen elektrischen Schaltung sind, umfassend mindestens die folgenden Schritte, die zyklisch wiederholend ausgeführt werden:

Messung der jeweiligen elektrischen Spannung gebildet durch eine Verschaltung der genannten Mehrzahl der elektrischen Energiespeicher in mindestens drei unterschiedlichen Schaltzuständen der genannten trennenden elektrischen Schaltelemente;
Digitalisierung der genannten gemessenen elektrischen Spannungen;
Übermittlung der digitalisierten gemessenen elektrischen Spannungen an mindestens eine integrierte elektrische Schaltung;
Schätzung der jeweiligen Spannungen der Energiespeicher durch die mindestens eine integrierte elektrische Schaltung durch Lösen einer Abbildungsschrift unter Einbeziehung der jeder Spannung zugehörigen Schaltzustände der genannten elektrischen Schaltelemente, wobei die zu ermittelnden Spannungen V(i, t) der elektrischen Energiespeicher der einzelnen Module i, als Koordinaten in einem Vektor $\mathbf{V}$(t) zusammengefasst, zu einem jeweiligen Zeitpunkt t und bei einem entsprechend aktuellen als Matrix $\mathbf{M}$(s(t)) dargestellten Schaltzustand s(t) der Module zu dem jeweiligen Zeitpunkt t auf eine von einer Gruppe (403) der mehreren entsprechenden Module i zusammen aktuell erzeugte und gemessene elektrische Spannung $V_{unit}$(s(t)) abgebildet und durch Auflösung nach $\mathbf{V}$(t) bestimmt werden:

$$V_{unit}(s(t)) = \mathbf{M}(s(t))\, \mathbf{V}(t),$$

wobei beim Bestimmen der Spannungen angenommen wird, dass sich die jeweiligen Spannungen der elektrischen Energiespeicher der einzelnen Module zu den verschiedenen Zeitpunkten nur unwesentlich ändern, und eine Reihe von verschiedenen Zeitpunkten t derart zusammengefasst wird, dass die zu bestimmenden Spannungen für diese Zeit als konstant betrachtet werden.

**Claims**

1.  Electrical circuit which contains at least two modules (401) which are similar to one another and each have at least one electrical energy store and at least one electronic switch which permits electrical connections of the at least one electrical energy store to the energy stores of other modules to be changed, wherein the electrical circuit also contains at least one voltage-measuring device (407) which is configured to measure electrical voltages, generated by a group (403) of a plurality of modules, in at least two different switched states of the modules, and to carry out automatic determination of the voltages of the electrical energy stores of the individual modules, wherein the at least two modules are considered to be similar if they can bring about at least two identical switched states which each define how the respective energy store is connected to the energy stores of the other modules in an electrically conductive fashion, wherein the group of modules contains at least two modules of the circuit, **characterized in that** the electrical circuit is configured to combine the voltages V(i, t) to be determined of the electrical energy stores of the individual modules i as coordinates in a vector V(t) and to map them onto an electrical voltage $V_{unit}$(s(t), currently produced by the group (403) of modules i together, at a respective time t and in an accordingly present switching state s(t) of the modules, which is depicted in a matrix M(s(t)), at the respective time t and to specify them by means of resolution according to V(t) :

    $$V_{unit}(s(t)) = M(s(t)) V(t),$$

    wherein the electrical circuit is additionally configured so as, when specifying the voltages, to assume that the respective voltages of the electrical energy stores of the individual modules change only insignificantly at the various times, and to combine a series of different times t such that the voltages to be specified are regarded as constant for this time.

2.  Circuit according to Claim 1, wherein the at least two modules are considered to be similar to one another if they can bring about at least two of the following three switched states:

    the at least one electrical energy store of a module is connected in series with the at least one energy store of another module using electrical switches;
    the at least one electrical energy store of a module is connected in parallel with the at least one energy store of another module using electrical switches;
    the at least one electrical energy store of a module is bypassed using electrical switches, which means that the at least one electrical energy store of a module is connected in an electrically conductive manner at maximum by just one of its at least two electrical contacts to an electrical energy store of another module, and therefore there is no closed circuit with an electrical energy store of another module.

3.  Circuit according to one of Claims 1 or 2, wherein the voltages of the electrical energy stores of at least two modules are determined in at least one estimation time (504) which comprises at least one integrated electronic circuit.

4.  Circuit according to Claim 3, wherein the at least one estimation time (504) receives, as input signals, at least one digitized measurement signal (506) of the electrical voltage generated by a group of a plurality of modules, from a measuring unit, and receives at least one signal (510) describing the current module state from at least one control unit.

5.  Circuit according to Claim 4, wherein the estimation is carried out according to a digital clock cycle at fixed time increments.

6.  Circuit according to Claim 5, wherein the estimation time contains at least one digital memory module which stores at least the module states and the measured values of the generated electrical voltages of a group of a plurality of modules of a plurality of elapsed digital clock cycles.

7.  Circuit according to one of Claims 4 to 6, wherein the estimation time of the control unit (505) transmits at least one signal (509) which describes the estimated module voltages of the individual modules.

8.  Circuit from one of Claims 1 to 7, wherein the device also measures, in addition to the voltage, the electrical current flowing into the group (403) of a plurality of modules, and uses it for the automatic determination of the module voltages of the individual modules.

9. Circuit from one of Claims 1 to 8, wherein the device also comprises at least two voltage-measuring apparatuses, each of which measures the electrical voltages, generated by a respectively associated group (403) of a plurality of modules, in at least two different switched states, wherein individual modules are part of a plurality of groups associated with the specified, in each case, at least one voltage-measuring apparatus; and wherein an estimation error of the determined voltages of the electrical energy stores of the individual modules is determined with the at least two voltage-measuring apparatuses, and/or a technical failure of at least one of the at least two voltage-measuring apparatuses is detected.

10. Circuit from one of Claims 1-9, wherein the device also contains at least one temperature-measuring apparatus which measures the temperature of a module (401) or at least of an electronic switch of a module (401) or at least of an electrical energy store of a module (401) or of a group (403) of a plurality of modules.

11. Method for determining respective voltages of a multiplicity of electrical energy stores, wherein in each case at least one electrical connection between the individual energy stores is separated from one another by in each case at least one electrical switching element, and wherein the multiplicity of electrical energy stores and disconnecting electrical switching elements are part of a modular electrical circuit, comprising at least the following steps which are carried out in a cyclically repeating fashion:

measurement of the respective electrical voltage formed by connection of the specified multiplicity of the electrical energy stores in at least three different switched states of the specified disconnecting electrical switching elements;
digitization of the specified measured electrical voltages;
transmission of the digitized measured electrical voltages to at least one integrated electrical circuit;
estimation of the respective voltages of the energy stores by the at least one integrated electrical circuit by resolving a mapping specification by including the switched states of the specified electrical switching elements which are associated with each voltage,

wherein the voltages $V(i, t)$ to be determined of the electrical energy stores of the individual modules i are combined as coordinates in a vector $V(t)$, are mapped onto an electrical voltage $V_{unit}(s(t))$, currently produced and measured by a group (403) of the multiple applicable modules i together, at a respective time t and in an accordingly present switching state $s(t)$ of the modules, which is depicted as a matrix $M(s(t))$, at the respective time t and are specified by means of resolution according to $V(t)$:

$$V_{unit}(s(t)) = M(s(t)) \ V(t),$$

wherein, when specifying the voltages, it is assumed that the respective voltages of the electrical energy stores of the individual modules change only insignificantly at the various times, and a series of different times t are combined such that the voltages to be specified are regarded as constant for this time.

**Revendications**

1. Circuit électrique contenant au moins deux modules différents (401) mais similaires qui contiennent chacun au moins une réserve d'énergie électrique et au moins un commutateur électronique qui permet de remplacer le raccordement électrique de la ou des réserves d'énergie électrique par celui des réserves d'énergie d'autres modules, le circuit électrique contenant en outre au moins un dispositif (407) de mesure de tension conçu pour mesurer les tensions électriques produites conjointement par un groupe (403) de plusieurs modules en au moins deux états de commutation différents des modules et pour transmettre automatiquement les tensions des réserves d'énergie électrique des différents modules, les deux ou plusieurs modules étant considérés comme similaires s'ils peuvent constituer au moins deux états de commutation identiques qui définissent chacun la manière suivant laquelle la réserve d'énergie est raccordée de manière électriquement conductrice aux réserves d'énergie des autres modules, le groupe de modules comportant au moins deux modules du circuit,
**caractérisé en ce que**

le circuit électrique est conçu pour rassembler en tant que coordonnées d'un vecteur V(t) les tensions V(i, t) à déterminer sur les réserves d'énergie électrique des différents modules i et pour, dans un état de commutation s(t) en cours correspondant des modules à un instant t, représenté par une matrice M(s(t)), les représenter par une tension électrique $V_{unit}$(s(t)) produite conjointement par un groupe (403) des modules i à cet instant t et les déterminer par résolution selon V(t):

$$V_{unit}(s(t)) = M(s(t)) \ V(t),$$

le circuit électrique étant en outre conçu pour supposer lors de la détermination des tensions que les différentes tensions des réserves d'énergie électrique des différents modules ne se modifient que de manière négligeable aux différents instants et pour rassembler une série de différents instants t de telle sorte que les tensions à déterminer soient considérées comme constantes pendant cette durée.

2. Circuit selon la revendication 1, dans lequel les deux ou plusieurs modules sont considérés comme similaires les uns aux autres s'ils peuvent constituer au moins deux des trois états de commutation suivants :

   la ou les réserves d'énergie électrique d'un module sont raccordées en série à la ou aux réserves d'énergie d'un autre module à l'aide de commutateurs électriques,
   la ou les réserves d'énergie électrique d'un module sont raccordées en parallèle à la ou aux réserves d'énergie d'un autre module à l'aide de commutateurs électriques,
   la ou les réserves d'énergie électrique d'un module sont contournées à l'aide de commutateurs électriques, ce qui signifie que la ou les réserves d'énergie électrique d'un module ne sont reliées de manière électriquement conductrice à une réserve d'énergie électrique d'un autre module qu'au plus par un de leurs deux ou plusieurs contacts électriques et qu'ainsi aucun circuit fermé de courant ne soit formé avec une réserve d'énergie électrique d'un autre module.

3. Circuit selon l'une des revendications 1 ou 2, dans lequel la détermination des tensions des réserves d'énergie électrique d'au moins deux modules s'effectue dans au moins une unité d'estimation (504) qui comporte au moins un circuit électronique intégré.

4. Circuit selon la revendication 3, dans lequel la ou les unités d'estimation (504) reçoivent comme signaux d'entrée provenant d'au moins une unité de mesure au moins un signal de mesure (506) de la tension électrique produite par un groupe de plusieurs modules et reçoivent d'au moins une unité de commande au moins un signal (510) qui décrit les états en cours des modules.

5. Circuit selon la revendication 4, dans lequel l'estimation s'y effectue à des pas temporels fixés au moyen d'une cadence numérique.

6. Circuit selon la revendication 5, dans lequel l'unité d'estimation contient au moins un ensemble de mémoire numérique qui conserve au moins les états des modules et les valeurs de mesure des tensions électriques produites lors de plusieurs cadences numériques passées par un groupe de plusieurs modules.

7. Circuit selon l'une des revendications 4 à 6, dans lequel l'unité d'estimation de l'unité de commande (505) transmet au moins un signal (509) qui décrit les tensions estimées des différents modules.

8. Circuit selon l'une des revendications 1 à 7, dans lequel le circuit mesure en plus de la tension le courant électrique qui pénètre dans les groupes (403) de plusieurs modules et en tient compte pour la détermination automatique des tensions des différents modules.

9. Circuit selon l'une des revendications 1 à 8, dans lequel le circuit comporte en outre au moins deux dispositifs de mesure de tension dont chacun mesure en au moins deux états de commutation différents des modules les tensions électriques produites conjointement par un groupe associé (403) de plusieurs modules, différents modules faisant partie de plusieurs desdits groupes associés chacun à au moins un dispositif de mesure de tension, une erreur d'estimation des tensions déterminées sur les réserves d'énergie électrique des différents modules étant déterminée par les deux ou plusieurs dispositifs de mesure de tension et/ou une détection d'une défaillance technique d'au moins l'un des deux ou plusieurs dispositifs de mesure de tension étant réalisée.

**10.** Circuit selon l'une des revendications 1 à 9, dans lequel le circuit contient en outre au moins un dispositif de mesure de température qui mesure la température d'un module (401), d'au moins un commutateur électronique d'un module (401) ou d'au moins une réserve d'énergie électrique d'un module (401) ou d'un groupe (403) de plusieurs modules.

**11.** Procédé de détermination des différentes tensions de plusieurs réserves d'énergie électrique, dans lequel au moins une liaison électrique entre les différentes réserves d'énergie est coupée par au moins un élément de commutation électrique, les différentes réserves d'énergie électrique et les éléments de commutation électrique assurant les séparations faisant partie d'un circuit électrique modulaire,
le procédé comportant au moins les étapes suivantes qui sont exécutées en répétition cyclique :

mesure de chaque tension électrique formée par un raccordement desdites réserves d'énergie électrique en au moins trois états de commutation différents desdits éléments de commutation électrique de séparation, numérisation desdites tensions électriques mesurées,
transmission à au moins un circuit électrique intégré des tensions électriques mesurées et numérisées,
estimation de chaque réserve d'énergie par le ou les circuits électriques intégrés par résolution d'une prescription de représentation qui tient compte des états de commutation associés à chaque tension pour lesdits éléments de commutation électrique, les tensions $V(i, t)$ à déterminer sur les réserves d'énergie électrique des différents modules $i$ étant rassemblées en tant que coordonnées d'un vecteur $V(t)$ et, dans un état de commutation $s(t)$ en cours correspondant des modules à un instant $t$, représenté par une matrice $M(s(t))$, représentées par une tension électrique $V_{unit}(s(t))$ produite conjointement par un groupe (403) des différents correspondants modules $i$ à cet instant $t$ et mesurée, et déterminées par résolution selon $V(t)$:

$$V_{unit}(s(t)) = M(s(t)) \ V(t),$$

le circuit électrique étant en outre conçu pour supposer lors de la détermination des tensions que les différentes tensions des réserves d'énergie électrique des différents modules ne se modifient que de manière négligeable aux différents instants et pour rassembler une série de différents instants $t$ de telle sorte que les tensions à déterminer soient considérées comme constantes pendant cette durée.

Fig. 1

Fig. 2

Fig. 3

Fig. 4

Fig. 5

Fig. 6

*Fig. 7*

*Fig. 8*

Fig. 9

*Fig. 10*

1109   1103

1101

1105

1106

1111

1107

1102

1112

1108

1110   1104

*Fig. 11*

Fig. 12

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7269037 B
- DE 10103031
- WO 2012072197 A
- DE 102010052934
- WO 2012072168 A
- EP 20110179321 A
- DE 20101052934
- WO 2013017186 A
- DE 102011108920
- US 13990463 B
- US 14235812 B
- DE 102010008978
- DE 102009057288
- US 3581212 A

**In der Beschreibung aufgeführte Nicht-Patentliteratur**

- **M. D. SEEMAN ; S. R. SANDERS.** Analysis and optimization of switched-capacitor dc-dc converters. *IEEE Transactions on Power Conversion,* 2008, vol. 23 (2), 841 ff
- **ERWIN MARX.** Erzeugung von verschiedenen Hochspannungsarten zu Versuchs- und Prüfzwecken. *Elektrotech. Zeitschrift,* 1925
- **J. RODRIGUEZ ; S. LEEB.** A multilevel inverter topology for inductively coupled power transfer. *IEEE Transactions on Power Electronics,* 2006, vol. 21 (6), 1607ff
- **F. PENG ; W. QIANG ; D. CAO.** Recent advances in multilevel converter/inverter topologies and applications. *International Power Electronics Conference (IPEC),* 2010, 492ff
- **L. ÄNQUIST ; A. ANTONOPOULOS ; D. SIEMASZKO ; K. ILVES ; M. VASILADIOTIS ; H.-P. NEE.** Open-loop control of modular multilevel Converters using estimation of stored energy. *IEEE Transactions on Industry Applications,* 2011, vol. 47 (6), 2516ff
- **GOETZ, S. M. et al.** Modular multilevel converter with series and parallel module connectivity: topology and control. *IEEE Transactions on Power Electronics,* 2014
- **A. LESNICAR ; R. MARQUARDT.** An innovative modular multilevel converter topology suitable for a wide power range. *IEEE Power Tech Conference Proceedings,* 2003, vol. 3, 6
- **GOETZ, S. M. et al.** Modular multilevel converter with series and parallel module Connectivity: topology and control. *IEEE Transactions on Power Electronics,* 2014